(19) Europäisches Patentamt
European Patent Office
Office européen des brevets

(11) EP 3 452 524 B1

(12) EUROPÄISCHE PATENTSCHRIFT

(45) Veröffentlichungstag und Bekanntmachung des Hinweises auf die Patenterteilung:
**03.03.2021 Patentblatt 2021/09**

(21) Anmeldenummer: **17711137.4**

(22) Anmeldetag: **15.03.2017**

(51) Int Cl.:
***C08F 220/32*** $^{(2006.01)}$ ***C09J 133/06*** $^{(2006.01)}$

(86) Internationale Anmeldenummer:
**PCT/EP2017/056048**

(87) Internationale Veröffentlichungsnummer:
**WO 2017/190878 (09.11.2017 Gazette 2017/45)**

(54) **WASSERDAMPFSPERRENDE KLEBEMASSE MIT HOCHFUNKTIONALISIERTEM POLY(METH)ACRYLAT**

WATER VAPOR-BLOCKING ADHESIVE COMPOUND HAVING HIGHLY FUNCTIONALIZED POLY(METH)ACRYLATE

MASSE ADHÉSIVE FAISANT BARRIÈRE À LA VAPEUR D'EAU, COMPRENANT DU POLY(MÉTH)ACRYLATE HAUTEMENT FONCTIONNALISÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.05.2016 DE 102016207540**

(43) Veröffentlichungstag der Anmeldung:
**13.03.2019 Patentblatt 2019/11**

(73) Patentinhaber: **tesa SE**
**22848 Norderstedt (DE)**

(72) Erfinder:
- **DOLLASE, Thilo**
  **22397 Hamburg (DE)**
- **GARGIULO, Jessika**
  **20255 Hamburg (DE)**
- **KUPSKY, Marco**
  **25451 Quickborn (DE)**
- **WEDEL, Bastian**
  **22149 Hamburg (DE)**

(74) Vertreter: **tesa SE**
**Hugo-Kirchberg-Straße 1**
**22848 Norderstedt (DE)**

(56) Entgegenhaltungen:
**JP-A- 2003 336 025 JP-A- 2008 150 406**
**US-B1- 6 319 603**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 452 524 B1

## Beschreibung

Die vorliegende Erfindung gemäß den vorliegenden Ansprüchen betrifft ein ein- oder doppelseitig klebendes Klebeband enthaltend härtbare Klebemasse zur Kapselung einer elektronischen oder optoelektronischen Anordnung gegen Permeaten.

Zur Verkapselung feuchtigkeitsempfindlicher organischer Aufbauten wie zum Beispiel organischer Leuchtdioden (OLEDs) werden spezielle Barriereklebemassen, die auch als wasserdampfsperrende Klebemassen bezeichnet werden, verwendet. Eine gute Klebemasse für die Versiegelung von (opto-)elektronischen Strukturen oder Anordnungen weist eine geringe Permeabilität gegen Sauerstoff und insbesondere gegen Wasserdampf auf, hat eine ausreichende Haftung auf der Anordnung und kann gut auf diese auffließen. Eine geringe Haftung auf der Anordnung verringert die Barrierewirkung an der Grenzfläche, wodurch ein Eintritt von Sauerstoff und Wasserdampf unabhängig von den Eigenschaften der Klebmasse ermöglicht wird. Nur wenn der Kontakt zwischen Masse und Substrat durchgängig ist, sind die Masseeigenschaften der bestimmende Faktor für die Barrierewirkung der Klebemasse.

Zur Charakterisierung der Barrierewirkung werden üblicherweise die Sauerstofftransmissionsrate OTR (Oxygen Transmission Rate sowie die Wasserdampftransmissionsrate WVTR (Water Vapor Transmission Rate, Test A) angegeben. Die jeweilige Rate gibt dabei den flächen- und zeitbezogenen Fluss von Sauerstoff beziehungsweise Wasserdampf durch einen Film unter spezifischen Bedingungen von Temperatur und Partialdruck sowie gegebenenfalls weiterer Messbedingungen wie relativer Luftfeuchtigkeit an. Je geringer diese Werte sind, desto besser ist das jeweilige Material zur Kapselung geeignet. Aus diesen Grundvoraussetzungen lässt sich ableiten, dass unpolare Materialien, die einen geringen WVTR und OTR aufweisen, besonders für Versiegelungsanwendungen geeignet sind, polare Materialien wie zum Beispiel Poly(meth)acrylate dagegen nicht. In DE 10 2008 047 964 A1 werden solche Unterschiede aufgezeigt. Die Angabe der Permeation basiert nicht allein auf den Werten für WVTR oder OTR, sondern beinhaltet immer auch eine Angabe zur mittleren Weglänge der Permeation wie zum Beispiel die Dicke des Materials oder eine Normalisierung auf eine bestimmte Weglänge.

Als wasserdampfsperrende Klebemassen oder Barriereklebemassen werden im Stand der Technik zur Randverkapselung von empfindlicher (opto)elektronischer Strukturen aktuell häufig Epoxidflüssigkleber verwendet. Für die flächige Verkapselung bieten sich Haftklebstoffe, Klebebänder und Klebefolien an. Dazu werden den flüssigen Epoxiden Polymere und Klebharze zugesetzt, sodass die Formulierungen haftklebrig werden. Versuche haben gezeigt, dass die Barriereperformance mit dem Anteil an Epoxidharz steigt.

Da die Barriereperformance mit dem Anteil an Epoxid in der Klebemasse steigt, ist es also wünschenswert hohe Epoxidanteile zu realisieren. Das Problem dabei ist jedoch, dass übliche Epoxide flüssig sind und somit mit steigendem Epoxidanteil die Filmeigenschaften abnehmen und sich negativ auf das Verarbeitungsverhalten (zum Beispiel Ausquetschneigung aus einer Klebefuge) auswirken. Aus diesem Grund sind aktuelle Barriereklebemassen in ihrem Epoxidgehalt begrenzt. Typischerweise wird die Viskosität von Epoxidharzen auf Epichlorhydrinbasis über das Verhältnis von Epichlorhydrin zu beispielsweise Bisphenol-A und einer daraus resultierenden leichten Molekulargewichtserhöhung eingestellt ["Epoxy Adhesive Formulations" 2006, E. M. Petrie, S.30ff]. Der Nachteil ist ein aufgrund des Herstellprozesses hoher Halogengehalt, der in Anwendungen in der Elektronikindustrie nicht geduldet wird. Durch Destillation lässt sich zwar das Epoxid aufreinigen (zum Beispiel Epikote 828 LVEL) jedoch funktioniert dies nur mit destillierbaren (flüssigen) Epoxiden von denen wiederum auf Grund der oben genannten daraus resultierenden Nachteile in den Verarbeitungseigenschaften keine hohen Anteile in die Klebemasse insbesondere für Klebefilme formuliert werden können. Eine weitere Möglichkeit sind sogenannte b-staged Epoxidsysteme. Dabei handelt es sich um Epoxidsysteme, die bereits leicht anvernetzt und somit nicht mehr flüssig sind. Der große Nachteil dieser Systeme ist jedoch, dass sie gekühlt ausgeliefert werden müssen, da die Vernetzungsreaktion sonst fortschreitet und die Epoxide vollständig vernetzen.

Unter dem Begriff "Ausquetschen" oder auch "Oozing" ist im Sinne dieser Erfindung ein seitliches Austreten der Klebemasse aus einer nicht ausgehärteten oder nicht ausreichend ausgehärteten Klebschicht oder einem Klebeverbund zu verstehen. Dies kann als kalter Fluss und/oder unter Druck und/oder bei erhöhter Temperatur geschehen und ist nicht erwünscht.

Speziellere Epoxidmonomere wie beispielsweise Epoxycyclohexyl-Derivate, die nicht über die Epichlorhydrinroute hergestellt werden, sind häufig sehr niedrigviskos. Ein Beispiel hierfür ist Uvacure 1500.

Es besteht daher Bedarf nach härtbaren Epoxiden, die im unvernetzten Zustand mit einer ausreichend hohen Viskosität zur Verfügung gestellt werden können, aber trotzdem unter Verklebungsbedingungen gut auf die zu verklebenden Substratoberflächen auffließen können, so dass durchgehender Kontakt zwischen Barriereklebemasse und Substratoberfläche erreicht werden kann. Unter dieser Voraussetzung sollten die gesuchten härtbaren Epoxide bzw. diese enthaltenden härtbaren Klebemassen gute wasserdampfsperrende Eigenschaften aufweisen und sich in Kombination mit ihren Verklebungseigenschaften gut für die Versiegelung empfindlicher (opto)elektronischer Strukturen eignen. Die härtbaren Epoxide sollen einfach herstellbar sein.

Unter den Barriereeigenschaften ist besonders die sogenannte Durchbruchzeit entscheidend ("Lag-time", Test B). Diese Eigenschaft beschreibt das Sperrvermögen einer Siegelschicht über diejenige Zeitdauer, über die die Siegelschicht Feuchtigkeit von empfindlichen Funktionselementen wie insbesondere organischer (Opto)elektronik abhält. Gesucht werden wasserdampfsperrende Klebemassen, die eine Durchbruchzeit nach Test B von mindestens 150 h, bevorzugt von mindestens 250 h aufweisen.

Die AU 758128 B2 beschreibt lagerstabile kationisch härtende multifunktionelle Epoxidabmischungen. Um zu erreichen, dass die multifunktionellen Epoxidharze lagerstabil sind, ist es nach dieser Schrift erforderlich, eine ungewollte vorzeitige Polymerisation zu vermeiden. Dies wird erreicht, indem bei der Polymerisation von multifunktionellen Epoxidmonomeren 0,0005 bis 10 Gew.-% eines organischen und/oder anorganischen Erdalkali- oder Alkalimetallverbindung zugegeben werden. Eine Polymerisation vor gewünschter Vernetzung soll also in jedem Fall vermieden werden. Neben der erfindungsgemäßen Stabilisierung dieser Klebmassen geht aus dieser Schrift hervor, dass für kationisch härtbare Flüssigkleber Epoxycyclohexylderivate besonders bevorzugt sind, so dass es wünschenswert wäre, auch aus diesem Monomer hochviskose Epoxide herstellen zu können.

Die SG 160949 B schlägt vor, Di-Epoxide mit Di-Isocyanaten zu reagieren. Aus dieser Mischung bilden sich cyclische Trimere (Isocyanurate) und Oxazolidinone mit einem gewichtsmittleren Molekulargewicht von kleiner 3.000 g/mol und einer niedrigen Polydispersität, die man dann wie Epoxide aushärten kann. Dabei ist erforderlich, dass mindestens difunktionelle Substanzen zum Einsatz kommen, da andernfalls keine reaktiven Gruppen für die nachfolgende Aushärtung zur Verfügung stehen. Die entstehenden Verbindungen weisen jedoch niedrige Viskositäten auf.

Härtbare Klebemassen auf Epoxidbasis, die in Form von Klebebändern zum Einsatz kommen, sind bekannt. Sie enthalten typischerweise eine Filmbildnerkomponente, wobei es sich um ein Elastomer, ein thermoplastisches Polymer oder ein thermoplastisches Elastomer handeln kann, und eine Reaktivkomponente häufig bestehend aus einem Reaktivharz, in diesem Fall Epoxid-basierend, und einem Härtersystem (auch als Aktivatorsystem oder Initiatorsystem bezeichnet). Beispiele sind in EP 1 028 151 B1 (Poly(meth)acrylat / niedermolekulares Epoxidharz), EP 620 259 A1 (Polyester / niedermolekulares Epoxidharz), EP 721 975 (Polyolefin / niedermolekulares Epoxidharz) und DE 195 19 499 A1 (thermoplastisches Polyurethan / niedermolekulares Epoxidharz) zu finden.

Unter dem Begriff "härtbare Klebemasse" ist im Sinne dieser Erfindung eine Zubereitung zu verstehen, die funktionelle Gruppen enthält, die durch Einwirkung einer Härter- / Initiator- / Aktivator-Komponente und gegebenenfalls in Kombination mit einem zusätzlichen Stimulus wie Wärme und/oder Strahlung an einer Reaktion teilnehmen kann, die zu einem Molmassenaufbau und/oder einer Quervernetzung zumindest eines Zubereitungsbestandteils führt.

Die Begriffe "Härter", "Initiator", "Aktivator" sind im Sinne dieser Erfindung synonym verwendet. Sie beschreiben Substanzen oder Substanzgemische, die eine Härtungsreaktion unter Beteiligung von Epoxid-Funktionalitäten herbeiführen können, gegebenenfalls in Kombination mit einem zusätzlichen Stimulus wie Wärme und/oder Strahlung.

Außerdem besteht bei härtbaren Klebemassen, die in Form von Klebebändern zum Einsatz kommen sollen, üblicherweise die Notwendigkeit, eine ausreichende Lagerstabilität unter Lagerbedingungen zu gewährleisten, so dass das Klebeband auf unkomplizierte Weise transportiert und bevorratet werden kann, bevor die eigentliche Reaktivität dann erst im Aktivierungsschritt und unter Aktivierungsbedingungen zu Tage tritt / treten soll. Ohne solche Latenz ist die Praktikabilität genannter Klebebänder eingeschränkt.

Hier eignen sich insbesondere kationisch härtbare Epoxid-Systeme und hier vor allem solche auf Basis (cyclo)aliphatischer Epoxide, die durch Aktivierung mittels eines säurebildenden Initiators entweder thermisch ("Thermal Acid Generator", TAG) und/oder unter Einwirkung ultravioletter Strahlung ("Photo Acid Generator", PAG) reagieren. (Cyclo)aliphatische Epoxide lassen sich mit diesen Initiatoren effizienter härten als Glycidylether (J. V. Crivello, J. Polym. Sci. A Polym. Chem., 1999, 37, 4241-54). Für die Formulierung basierend auf (cyclo)aliphatischen Epoxiden, die sich für eine derartige Aktivierung besonders eignen, steht dem Fachmann allerdings bei weitem nicht ein solcher Reichtum an verschiedenen Reaktivharzen zur Verfügung wie bei Glycidyletherbasierenden Reaktivharzen. Die verfügbaren Reaktivharze auf Basis (cyclo)aliphatischer Epoxide liegen darüber hinaus niedermolekular vor, was zum Problem des Ausquetschens unter Heissverpressbedingungen oder sogar bei Raumtemperatur führen kann, da die noch nicht umgesetzten niedermolekularen Reaktivharze als Weichmacher fungieren. Es werden daher Reaktivharze gesucht für Klebemassen und hier insbesondere für Klebemasse in Filmform, die die beschriebenen Nachteile nicht oder in reduzierter Form aufweisen.

***Stand der Technik***

WO 98/21287 A1 beschreibt durch Strahlung härtbare Vorstufen für thermisch härtbare Klebesysteme enthaltend (a) einen strahlenhärtbaren Monomer-/Präpolymersirup, der vor allem als Poly(meth)acrylat-Komponente zu verstehen ist, (b) eine Epoxidharzkomponente, (c) eine Photoinitiatorkomponente und (d) einen nukleophilen thermischen Aktivator. Oligomere und polymere Epoxide können als Komponente (b) zum Einsatz kommen. Mit cycloaliphatischen Epoxiden funktionalisierte (Co)Polymere werden nicht explizit genannt. Cycloaliphatische Epoxide werden sogar grundsätzlich als wenig vorteilhaft beschrieben, siehe Seite 19, Zeile 2 der betreffenden Schrift. Härtung mittels TAG oder PAG ist nicht vorgesehen. Verwendungen im Bereich der Versiegelung empfindlicher (opto)elektronischer Strukturen sind nicht vorgesehen.

US 4,552,604 A ist ein weiteres Beispiel für ein sogenanntes "dual cure" System, bei dem ein Poly(meth)acrylat durch Photopolymerisation unter Beisein eines Epoxid-Harzes aufgebaut wird. Die Photopolymerisation der flüssigen Zusammensetzung erfolgt auf einem Liner. Der photopolymerisierte Film wird für die Verklebung schließlich thermisch zur Härtung gebracht. Die Photopolymerisation wird genutzt, um eine polymere Matrix für die thermisch härtbare Epoxidkomponente zu bilden. Die Härtung mit Supersäure bildenden Initiatoren wird nicht genannt. Verwendungen im Bereich der Versiegelung empfindlicher (opto)elektronischer Strukturen sind nicht vorgesehen.

EP 2 545 132 A1 offenbart einen photohärtbaren Haftklebestoff, der auf einem Polyacrylat basiert. Das Polyacrylat enthält zu einem geringen Anteil ein Epoxid-funktionalisiertes Comonomer, über das die Vernetzung des Haftklebstoffs erfolgen kann. Der Anteil an Epoxid-funktionalisiertem Comonomer ist sehr gering, so dass über die beschriebenen Copolymere ohne weiteres keine Reaktivklebebänder mit Verklebungsfestigkeiten deutlich oberhalb der durch Haftklebemassen erhalten werden können. Verwendungen im Bereich der Versiegelung empfindlicher (opto)elektronischer Strukturen sind nicht vorgesehen.

EP 819 746 A1 beschreibt härtbare Klebefolien, deren Formulierung ein hochmolekulares Polyacrylat, eine photopolymerisierbare Epoxidkomponente und einen kationischen Photoinitiator enthält. Das Polyacrylat kann ebenfalls, der Beschreibung nach zu geringen Anteilen wie zum Beispiel ca. 2 % des Copolymers, Epoxidgruppen enthalten. Im Hinblick auf die Epoxidkomponente wird keine spezielle Auswahl getroffen. Verwendungen im Bereich der Versiegelung empfindlicher (opto)elektronischer Strukturen sind nicht vorgesehen.

EP 914 027 A1 beschreibt ebenfalls härtbare Klebefolien, die ein Polyacrylat, eine Epoxid-Komponente und einen latenten Härter enthalten können. Das Polyacrylat kann geringe Anteile an Glycidyl(meth)acrylat enthalten. Verwendungen im Bereich der Versiegelung empfindlicher (opto)elektronischer Strukturen sind nicht vorgesehen.

WO 2013/101693 A1 offenbart thermisch härtbare Klebefilme erzeugt aus einem Acrylatmonomergemisch, das mittels Photoinitiierung radikalisch polymerisiert wird, und einer Epoxid-Komponente. Epoxidfunktionalisierte (Meth)acrylat Monomere sind nicht genannt. Verwendungen im Bereich der Versiegelung empfindlicher (opto)elektronischer Strukturen sind nicht vorgesehen.

WO 2015/048012 A1 beschreibt ein thermisch härtbares Haftklebesystem, das eine Polymethacrylat-Komponente enthält, die mit Benzoxazinen reagieren kann. Sie kann dazu u. a. Epoxid-Gruppen, bevorzugt über Glycidylmethacrylat als Comonomer ins Polymer eingebracht, enthalten. Der Beschreibung sind Glasübergangstemperaturen zu entnehmen, die über die sogenannte. Fox-Gleichung (U. W. Gedde, Polymer Physics, 1999, Kluwer, Dortrecht, S. 70) berechnet werden. Die Fox-Gleichung erlaubt eine rechnerische Abschätzung der Glasübergangstemperatur einer homogenen Mischung und nutzt hierfür die Glasübergangstemperaturen der Ausgangskomponenten der Mischung, gewichtet über den jeweiligen Mischungsanteil dieser Komponenten. Die dort eingesetzten Grunddaten beziehen sich auf Glasübergangstemperaturen für hypothetische Homopolymere des entsprechenden Comonomers. Hierzu kann man sich Tabellenwerten bedienen, die für Homopolymere mit sehr hohen Molmassen, nämlich solchen, bei denen sich die Glasübergangstemperatur nicht mehr mit dem Molekulargewicht ändert, gelistet sind. Die genannte Fox-Gleichung ist nicht zu verwechseln mit der sogenannten Fox-Flory-Beziehung (Gleichung G1), die den Einfluss der Polymermolmasse auf die Glasübergangstemperatur beschreibt. Bei den in der WO 2015/048012 A1 beschriebenen Polymeren kann daher von sehr hohen Molekulargewichten ausgegangen werden und die Nutzung von Polymeren mit geringerem Molekulargewicht wurde offenbar nicht in Erwägung gezogen. Verwendungen im Bereich der Versiegelung empfindlicher (opto)elektronischer Strukturen sind nicht vorgesehen.

WO 1999/057216 A1 offenbart Formulierungen enthaltend Ethylenvinylacetat-Copolymere und eine Epoxid-Komponente, die auch ein Polymerisat sein kann. Als konkretes Beispiel wird ein Polymer enthaltend Glycidylmethacrylat aufgeführt. Polymere (cyclo)aliphatischer Epoxid substituierter (Meth)acrylate sind nicht genannt. Verwendungen im Bereich der Versiegelung empfindlicher (opto)elektronischer Strukturen sind nicht vorgesehen.

WO 2012/165259 A1 beschreibt polymerisierbare Flüssigklebeformulierungen, die durch UV-Strahlung zur Härtung gebracht werden. Dazu enthalten die Formulierungen Monomere, die cycloaliphatische Epoxid-Gruppen und (Meth)acrylat-Gruppen tragen. Die Formulierungen enthalten zudem einerseits Photoinitiatoren für die radikalische Polymerisation der (Meth)acrylat-Gruppen und andererseits Photoinitiatoren für die kationische Polymerisation der Epoxid-Gruppen. Bestrahlung initiiert dann gleichzeitig beide Reaktionsprozesse. Die Formulierungen weisen die für Flüssigklebesysteme üblichen Nachteile wie Geruch und Ausquetschneigung bei der Applikation auf. Zudem kann sich der radikalische Härtungsprozess als nachteilig auswirken, da diese Art der Härtung nur während der Bestrahlung abläuft und die Härtungsreaktion über diesen Mechanismus Klebstoff in Schattenbereichen nicht erreicht. Verwendungen im Bereich der Versiegelung empfindlicher (opto)elektronischer Strukturen sind nicht vorgesehen.

US 2010/0137530 A1 offenbart Epoxid-Klebemassen enthaltend ein niedermolekulares und eine hochmolekulares Epoxid-Harz. Bei den Epoxid-Harzen handelt es sich um Oligomerisate von Glycidylethern. Für die Klebemasse wird die Verwendung als Siegelmasse für OLEDs vorgeschlagen. Nachteilig in diesen Systemen ist jedoch typischerweise der Halogengehalt und damit verknüpft die Notwendigkeit aufwändiger Verfahren zu deren Eliminierung für Anwendungen zum Beispiel im Elektronikbereich.

Weitere Klebemasse und Klebebänder werden in JP 2003 336025 A, US 6 319 603 B1 und JP 2008 150406

A beschrieben.

Es wurde nun gefunden, dass Klebemassen enthaltend ein mit, insbesondere (cyclo)aliphatischen, Epoxidgruppen funktionalisiertes (Co)poly(meth)acrylat für die gestellte Aufgabe sehr gut geeignet sind. Dies ist überraschend, da die geforderte Barrierewirkung auf Grund der Polarität des Poly(meth)acrylat-Rückgrats dieser Art eines Basis(co)polymers nicht zu erwarten war.

Die Erfindung betrifft ein ein- oder doppelseitig klebendes Klebeband enthaltend härtbare Klebemassen für die Versiegelung (opto)elektronischer Bauteile, bestehend aus den folgenden Komponenten:

(A) 20 bis 99,9 Gew.-% (bezogen auf die Gesamtheit der härtbaren Klebemasse) eines mit Epoxygruppen funktionalisierten (Co)Polymers mit einer gewichtsmittleren Molmasse im Bereich von 5 000 g/mol bis 200 000 g/mol, auf Basis von mehr als 30 bis 100 Gew.-%, bevorzugt 50 bis 100 Gew.-%, (bezogen auf die Gesamtheit der dem epoxidfunktionalisierten (Co)Polymer zugrundeliegenden Monomere) zumindest einer Sorte eines mit einer Epoxy-Gruppe funktionalisierten (meth)acrylischen (Co)Monomers (a),
(B) 0,1 bis 5 Gew.-% (bezogen auf die Gesamtheit der härtbaren Klebemasse) zumindest eines Härters, der thermisch und/oder durch Zufuhr von UV-Strahlung die - insbesondere kationische - Härtung des (Co)Polymers (A) unter Reaktion seiner Epoxy-Gruppen induzieren kann,
(C) optional 0 bis 79,9 Gew.-% weiterer Bestandteile.

Die Angaben zu Molmassen beziehen sich auf die Messung mittels GPC gemäß Messmethode C.

Der Begriff "(Co)Polymer" wird im Sinne dieser Erfindung zusammenfassend für Homopolymere oder Copolymere verwendet. Sofern im Rahmen der Schrift von Polymeren gesprochen wird, sind damit (Co)Polymere gemeint, sofern sich aus dem jeweiligen Bezug nichts anderes ergibt.
Unter dem Begriff "(Co)poly(meth)acrylat" sind im Sinne dieser Erfindung Polyacrylat- und Polymethacrylat-Homopolymere oder Copolymere aus (meth)acrylischen Monomeren sowie gegebenenfalls weiteren copolymeriserbaren Comonomeren zu verstehen.
Mit dem Begriff "(Meth)Acrylate" und dem Adjektiv "(meth)acrylisch" werden zusammenfassend die Verbindungen aus der Gruppe aus Acrylsäurederivaten - wie insbesondere Acrylsäureester - und Methacrylaten - wie insbesondere Methacrylsäureester - bezeichnet.
"(Co)Polymerisierbar" bedeutet im Sinne dieser Erfindung das Vermögen einer Monomersorte bzw. eines Gemischs zumindest zweier Monomersorten durch Molmassenaufbau ein (Co)Polymer zu bilden.

In bevorzugter Weise beträgt die gewichtsmittlere Molmasse des epoxidfunktionalisierten (Co)Polymers (A) mindestens 10 000 g/mol, sehr bevorzugt mindestens 20 000 g/mol. Weiter bevorzugt beträgt die gewichtsmittlere Molmasse des epoxidfunktionalisierten (Co)Polymers (A) höchstens 150 000 g/mol, sehr bevorzugt höchstens 100 000 g/mol,

Entsprechend des Anteils in der Gesamtheit der dem epoxidfunktionalisierten (Co)Polymer zugrundeliegenden Monomere haben die mit einer Epoxy-Gruppe funktionalisierten (meth)acrylischen (Co)Monomere (a) einen (Co)Monomeranteil im epoxidfunktionalisierten (Co)Polymer von mehr als 30 Gew.-% bis 100 Gew-%, bevorzugt von mindestens 50 Gew.-%.

In sehr bevorzugter Weise wird als mit einer Epoxy-Gruppe funktionalisiertes (meth)acrylisches (Co)Monomer (a) ein cycloaliphatisches Epoxid eingesetzt, beziehungsweise werden, wenn mehrere mit einer Epoxy-Gruppe funktionalisierten (meth)acrylischen (Co)Monomere (a) vorhanden sind, für eines, mehrere oder alle dieser mit einer Epoxy-Gruppe funktionalisierten (meth)acrylischen (Co)Monomere (a) cycloaliphatische Epoxide eingesetzt. Insbesondere vorteilhaft werden für mehr als 50 Gew.-% der (Co)Monnomere (a) cycloaliphatische Epoxide eingesetzt, besonders bevorzugt werden im Sinne der (Co)Monomere (a) ausschließlich cycloaliphatische Epoxide eingesetzt

Die zumindest eine Sorte eines funktionalisierten (Co)Polymers kann optional Bausteine umfassen, die auf folgende Monomere zurückzuführen sind (wobei dann jedenfalls ein Copolymer vorliegt), wobei jede der nachfolgend genannten Monomersorten (b), (c) und (d) unabhängig von der Anwesenheit der jeweils anderen Monomersorten vorliegen kann:

(b) eine oder mehrere Sorten Comonomere mit einer Glasübergangstemperatur von mindestens 25 °C, insbesondere mindestens 50 °C,
mit einem Comonomeranteil im Copolymer von 0 Gew-% bis weniger als 70 Gew-%, bevorzugt bis höchstens 50 Gew.-%,
und/oder
(c) eine oder mehrere Sorten Comonomere mit einer Glasübergangstemperatur von unterhalb 25 °C, insbesondere höchstens 0 °C,
mit einem Comonomeranteil im Copolymer von 0 Gew.-% bis weniger als 70 Gew.-%, bevorzugt bis höchstens 50 Gew.-%,

und/oder

(d) eine oder mehrere Sorten Comonomere, die zumindest eine andere Funktionalität als eine Epoxy-Gruppe tragen, insbesondere eine Silizium-haltige Gruppe,

mit einem Comonomeranteil im Copolymer von 0 Gew.-% bis 10 Gew.-%, bevorzugt bis 5 Gew.-%.

Mit Monomeranteil bzw. (Co)Monomeranteil im (Co)Polymer wird im Rahmen dieser Schrift der Anteil der auf diese (Co)Monomere zurückzuführenden Wiederholungseinheiten (Bausteine) in dem betreffenden Polymer bezeichnet.

Die Monomeranteile in der für die Herstellung des entsprechenden Copolymers zu polymerisierenden Polymermischung werden vorteilhaft entsprechend gewählt.

Angaben zu Glasübergangstemperaturen in dieser Schrift beziehen sich auf die Messung mittels DSC nach Methode D1.

Der Anteil des funktionalisierten (Co)Polymers (A) in der härtbaren Klebemasse beträgt mindestens 20 Gew.-%, bevorzugt mindestens 50 Gew.-%, sehr bevorzugt mindestens 70 Gew.-%. Sie kann auch bis zu 99,9 Gew.-% der Klebemasse betragen.

Bevorzugt liegt die Glasübergangstemperatur des ungehärteten funktionalisierten (Co)Polymers (A) bei mindestens 0 °C, sehr bevorzugt bei mindestens 25 °C oder sogar bei mindestens 35 °C. Sie liegt höchstens bei 100 °C und bevorzugt bei höchstens 80 °C. In alternativer Ausführung der Erfindung kann die Glasübergangstemperatur des funktionalisierten (Co)Polymers (A) aber auch unter 0 °C liegen.

Der Anteil an dem zumindest einen Härter (B) an der Klebemasse liegt bei mindestens 0,1 Gew.-% bis zu bevorzugt höchstens 5 Gew.-%. Sehr bevorzugt werden mindestens 0,3 Gew.-% bis 3 Gew.-%, bezogen auf die Gesamtformulierung der härtbaren Klebemasse.

Der Anteil an weiteren optionalen Bestandteilen (C) liegt, sofern solche zum Einsatz kommen und je nach Art des Bestandteils, bei höchstens 79,9 Gew.-%, insbesondere bei höchstens 69,9 Gew.-%, bevorzugt bei höchstens 49,9 Gew.-%, sehr bevorzugt bei höchstens 29,9 Gew.-%, bezogen auf die Gesamtformulierung der härtbaren Klebemasse.

In bevorzugter Weise weist die härtbare Klebemasse im nicht gehärteten Zustand eine erste Glasübergangstemperatur auf, die unterhalb derjenigen Temperatur liegt, bei der der Klebeverbund bestehend aus Reaktivklebefilm und zu verklebenden Substraten durch Lamination erstellt wird, so dass die Formulierung unter den Laminierbedingungen unter Druck in einem definierten Zeitraum ein ausreichendes Benetzen auf dem Substrat / den Substraten erlaubt. Die für die Laminierung genutzte Temperatur wird im Sinne dieser Erfindung "Laminiertemperatur" genannt. Die Temperaturdifferenz zwischen der Laminiertemperatur und Glasübergangstemperatur liegt vorzugsweise bei mindestens etwa 40 °C, insbesondere bei mindestens etwa 70 °C oder sogar bei mindestens 100 °C, wobei die Laminiertemperatur oberhalb der Glasübergangstemperatur liegt. Die Laminiertemperatur liegt vorteilhaft zwischen 40 °C und 100 °C, insbesondere zwischen 50 °C und 80 °C. Sie liegt unterhalb der Aktivierungstemperatur, also derjenigen Temperatur, bei der die Härtung der härtbaren Klebemasse initiiert wird, sofern es sich um eine thermisch aktivierbare Klebemasse handelt. Die Differenz zwischen Laminiertemperatur und Aktivierungstemperatur liegt in diesem Fall vorteilhaft bei mindestens 20 °C, insbesondere bei mindestens 40 °C.

Die Glasübergangstemperatur für die gehärtete Klebemasse dagegen liegt sehr bevorzugt um mindestens 40 °C, insbesondere um mindestens 100 °C höher als für das nicht gehärtete Klebesystem. Durch die hohe Anzahl an reaktiven Gruppen im (Co)Polymer (A) und gegebenenfalls in weiteren Bestandteilen (C) kann es möglich sein, dass eine Glasübergangstemperatur im gehärteten Zustand auf Grund des hohen Vernetzungsgrads nicht bestimmbar ist bzw. oberhalb der Zersetzungstemperatur liegt.

Weiter vorteilhaft liegt die Glasübergangstemperatur für das gehärtete (Co)Polymer (A) selbst um mindestens 40 °C, insbesondere um mindestens 100 °C höher als für das nicht gehärtete (Co)Polymer. Durch die hohe Anzahl an reaktiven Gruppen im (Co)Polymer (A) kann es möglich sein, dass eine Glasübergangstemperatur im gehärteten Zustand auf Grund des hohen Vernetzungsgrads nicht bestimmbar ist bzw. oberhalb der Zersetzungstemperatur liegt.

Die Titulierung "gehärtetes System" oder "gehärtete Klebemasse" bedeutet im Sinne dieser Erfindung, dass die Klebemasse mit dem funktionalisierten (Co)Polymer (A) durch Einwirkung der Härter-Komponente und gegebenenfalls einen weiteren Stimulus wie Wärme und/oder Strahlung aktiviert wurde und eine Reaktion unter Beteiligung der funktionellen Gruppen des (Co)Polymers (A) stattgefunden hat. Es brauchen aber nicht alle funktionellen Gruppen, die chemisch an der Härtungsreaktion teilnehmen können, reagiert zu haben. Vielmehr kann auch ein Umsatz von 50 % der funktionellen Gruppen bereits eine ausreichend hohe Glasübergangstemperatur mit sich bringen und für die Siegelanwendung sehr gut geeignet sein. Ein Umsatz von 50 % ist hier beispielhaft genannt. Ebenso kann die gemachte Aussage auch auf höhere wie 60 %, 70 %, 80 % oder 90 % oder sogar niedrigere Umsätze wie 40 % oder 30 % gelten. Entscheidend ist, dass die Barriereeigenschaften nach durchgeführter Härtung anwendungsgerecht sind, d. h. die Durchbruchzeit nach Test B bei mindestens 150 h liegt.

Die Klebemasse kann unter Standardbedingungen (23 °C, 50 % rel. Luftfeuchtigkeit) haftklebrig sein. Sie weist dann im nicht gehärteten Zustand eine Glasübergangstemperatur von unter 0 °C, vorzugsweise von höchstens -25 °C auf. Diese Charakteristik vereinfacht Konfektionierprozesse wie die Vordimensionierung von Klebebandabschnitten für

den späteren Verklebungsprozess oder auch Laminierschritte bei der Herstellung von Klebeproduktaufbauten und Bauteilverklebung. Im Laminierprozess braucht in diesem Fall nicht unbedingt mit erhöhter Temperatur gearbeitet zu werden sondern kann bei Raumtemperatur laminiert werden, da bereits über den Laminationsdruck ein ausreichender Kontakt zwischen Klebmasse und den zu verklebenden Substraten realisiert werden kann. Für die Härtung bietet sich in diesem Fall vorzüglich UV-Strahlung an. Thermische Aktivierung ist jedoch auch möglich.
Unter dem Begriff "Haftklebemasse" beziehungsweise "haftklebrige Klebemasse" (PSA; englisch: "pressure sensitive adhesives") werden wie üblich solche viskoelastischen, polymeren Massen verstanden, die - gegebenenfalls durch geeignete Additivierung mit weiteren Komponenten, wie beispielsweise Klebharzen - bei der Anwendungstemperatur (sofern nicht anders definiert, bei Raumtemperatur, also 23 °C) dauerhaft klebrig und permanent klebfähig sind und an einer Vielzahl von Oberflächen bei Kontakt anhaften, insbesondere sofort anhaften (die einen sogenannten "Tack" [auch als Klebrigkeit oder Anfassklebrigkeit bezeichnet] aufweisen). Sie sind in der Lage, bereits bei der Anwendungstemperatur ohne eine Aktivierung durch Lösemittel oder durch Wärme - gegebenenfalls unter Einfluss eines mehr oder weniger hohen Druckes - ein zu verklebendes Substrat hinreichend zu benetzen, damit sich zwischen der Masse und dem Substrat für die Haftung hinreichende Wechselwirkungen ausbilden können.

Die Klebemasse kann unter Standardbedingungen (23 °C, 50 % rel. Luftfeuchtigkeit) aber auch nicht oder nur gering haftklebrig sein. Um dies einzustellen, weist sie dann im nicht gehärteten Zustand eine Glasübergangstemperatur von typischerweise mindestens 0 °C, vorzugsweise von mindestens 25 °C auf. Diese Charakteristik erlaubt ein vorteilhaftes Platzieren der Klebeprodukte im Verklebungsprozess und kein vorzeitiges Anhaften an eine Oberfläche in falscher Position. Darüber hinaus zeigt sich diese Charakteristik vorteilhaft für latentreaktive Klebesysteme, da etwaige Reaktivität im glasigen / zähelastischen Zustand signifikant (kinetisch) herabgesetzt ist und man dadurch eine verbesserte Latenz erreicht. Für den Laminierprozess ist dann neben Druck aber auch eine erhöhte Temperatur erforderlich.

Bei Applikation, insbesondere Lamination unter Erwärmung und Verpressung, erweicht das Klebesystem, nimmt in seinem Benetzungsverhalten zu und kann dadurch zu den zu verklebenden Substraten Kontakt ausbilden. In diesem Zusammenhang ist die Molmasse des erfindungsgemäßen funktionalisierten (Co)Polymers (A) von zentraler Bedeutung, da sie bei gegebener Zusammensetzung die viskoelastischen Eigenschaften der Schmelze und hier insbesondere die Schmelzviskosität mit beeinflusst. Je höher die Molmasse, desto ausgeprägter wirken sich Verschlaufungen als temporäre Vernetzungspunkte auf das viskoelastische Verhalten aus. Liegt die Molmasse des erfindungsgemäßen funktionalisierten (Co)Polymers (A) unterhalb seines Verschlaufungsmolekulargewichts, sind entsprechende diese (Co)Polymere enthaltende Klebemassen unter Verpressbedingungen, also oberhalb der Glasübergangstemperatur, sehr fließfähig und bergen die Gefahr zu starken Ausquetschverhaltens. Liegt die Molmasse dagegen zu hoch, nämlich im Molmassenbereich, in dem sich die Glasübergangstemperatur nicht mehr mit der Molmasse ändert, ist das Polymer bereits zu stark verschlauft, wodurch das Fließverhalten reduziert wird, so dass unter Verpressbedingungen kein gutes Auffließen der Klebemasse mehr gewährleistet ist.

Das erfindungsgemäße funktionalisierte (Co)Polymer (A) bietet zudem einen weiteren Vorteil. Die Erfindung macht sich nämlich die Erkenntnis zu Nutze, dass ein Reaktivsystem im Verklebungsschritt, bei dem Ausquetschen auftreten kann, durch Aktivierung der Härtungsreaktion einen Aufbau an Molekulargewicht durchläuft. Dabei finden zwei Prozesse statt, Kettenwachstum und Quervernetzung. Beide Prozesse sind kinetisch kontrolliert und benötigen Zeit. Kommt unter Verklebungsbedingungen Wärme zum Einsatz, dann wird die Viskosität des Systems entsprechend ihrer Temperaturabhängigkeit reduziert, was zu Ausquetschen führen kann. Erfolgt der Molekulargewichtsaufbau nicht rasch genug, kann er durch die Molmassenabhängigkeit der Viskosität, die der Temperaturabhängigkeit der Viskosität prinzipiell entgegenwirkt, nicht den durch Wärmeeintrag bedingten Viskositätsabfall kompensieren. Die Folge ist unerwünschtes Ausquetschen von Klebematerial und ein unsauberes Verklebungsresultat.

Erfindungsgemäße (Co)Polymere (A) weisen aber bereits eine Basismolmasse auf, so dass zumindest ein erster Schritt des Kettenwachstums bereits vor der Aktivierung erfolgt ist und lediglich eine Quervernetzung zum Aufbau von Kohäsion ablaufen braucht. Weiterer Molmassenaufbau läuft nach der Aktivierung natürlich auch ab und führt zusammen mit der Quervernetzung zu vorteilhaften feuchtigkeitssperrenden Eigenschaften.

Im Folgenden werden die einzelnen Bestandteile Klebemassen genauer beschrieben, wobei die Aufzählungen als Beispiele zu verstehen sind.

(Co)Polymere (A)

Erfindungsgemäß werden reaktive (Co)Polymere mit einer Molmasse ausgewählt, die nicht zu niedrig ist und zwar mindestens 5 000 g/mol, bevorzugt mindestens 10 000 g/mol, sehr bevorzugt mindestens 20 000 g/mol. Diese Mindestmolmasse ist wichtig, damit die (Co)Polymere nicht zu einer zu ausgeprägten Fließfähigkeit der Klebemasse führen. Sehr vorteilhaft sind zudem (Co)Polymere, deren Molmasse nicht zu hoch ist und zwar bevorzugt bei höchstens 200 000 g/mol, weiter bevorzugt bei höchstens 150 000 g/mol, sehr bevorzugt bei höchstens 100 000 g/mol liegt. Die bevorzugte Maximalmolmasse bietet Vorteile im Verklebungsprozess. (Co)Polymere mit zu hoher Molmasse weisen reduziertes Auffließverhalten auf die zu verklebenden Substrate im Verklebungsprozess auf. Bevorzugt werden daher

(Co)Polymere aus demjenigen Molmassenbereich ausgewählt, in dem die Glasübergangstemperatur des ungehärteten reaktiven (Co)Polymers von der Molmasse abhängt. Die Abhängigkeit zwischen Polymer-Molmasse, M, und Glasübergangstemperatur, $T_G$, an sich ist bekannt und näherungsweise durch die Fox-Flory-Beziehung

$$1/T_G = 1/T_G^{\infty} + \text{const} / M \qquad \text{(G1)}$$

beschrieben, wobei $T_G^{\infty}$ die Glasübergangstemperatur eines Polymers ist, bei der sich $T_G$ nicht mehr mit der Molmasse ändert, und const eine Polymertyp-abhängige Konstante (T. Fox, P. J. Flory, J. Polym. Sei., 1954, 14, 315-319). Es wurde nämlich gefunden, dass reaktive (Co)Polymere in ihrem ungehärteten Zustand in diesem Molmassenbereich ein ausgezeichnetes viskoelastisches Verhalten für einen Verpressprozess / Laminierprozess aufweisen, und zwar eine besonders vorteilhafte Balance aus Auffließvermögen und Ausquetschverhalten, insbesondere für den Fall, dass die Verpresstemperatur oberhalb der Glasübergangstemperatur liegt. Einen weiteren Vorteil von Klebemassen mit solchen (Co)Polymeren ist die Dimensionsstabilität auf ihnen basierender Klebeschichten.

(Co)Monomere (a)

Für die (Co)Monomere (a) werden Monomere der Formel (I)

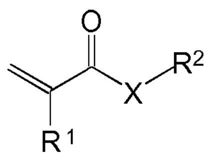
(I)

verwendet, wobei $-R^1$ gleich -H oder $-CH_3$, -X- gleich $-N(R^3)-$ oder -O- , $-R^3$ gleich -H oder $-CH_3$ und $-R^2$ eine Epoxy-funktionalisierte (Hetero)hydrocarbylgruppe darstellen. Weiter bevorzugt umfasst die Gruppe $R^2$ lineare, verzweigte, cyclische oder polycyclische Kohlenwasserstoffe mit 2 bis 30 Kohlenstoffatomen, welche mit einer Epoxygruppe funktionalisiert sind. Besonders bevorzugte Vertreter dieser Gruppe sind 3,4-Epoxycyclohexyl-substitituierte Monomere wie beispielsweise 3,4-Epoxycyclohexylmethylmethacrylat, 3,4-Epoxycyclohexylmethylacrylat, 3,4-Epoxycyclohexylmethacrylat, 3,4-Epoxycyclohexylacrylat.

Weniger bevorzugte, aber von der Erfindung dennoch umfasste (Co)Monomere (a) sind Glycidylgruppen-haltige (Co)Monomere wie Glycidylacrylat oder Glycidylmethacrylat. Die Härtungseigenschaften der Oxiraneinheiten in Glycidylgruppen unterscheiden sich insbesondere bei kationischer Härtung jedoch von denen (cyclo)aliphatischer Epoxide. Zudem enthalten Glycidylether-basierende Systeme aus Gründen ihrer Herstellprozesse meistens Resthalogen. Die erfindungsgemäßen Klebemassen weisen aber bevorzugt einen sehr niedrigen Halogengehalt (< 1000 ppm, bevorzugt sogar < 100 ppm), insbesondere bezogen auf Chlor und Brom, auf.

Über den Anteil an (Co)Monomeren (a) in den (Co)Polymeren (A) lassen sich neben den Barriereeigenschaften auch mechanische Eigenschaften der Klebemasse einstellen, da über den Anteil an Epoxidgruppen im (Co)Polymer (A) während der Härtung die Vernetzungsdichte eingestellt werden kann. Niedrige Anteile an (Co)Monomer (a) führen zu weniger elastischen Klebeschichten, höhere Anteile zu ausgeprägter elastischen Klebeschichten, jeweils im Hinblick auf die viskoelastischen Eigenschaften.

Comonomere (b)

Comonomere (b) weisen insbesondere keine Epoxy-Gruppen auf. Im Sinne der Comonomere (b) sind alle dem Fachmann bekannten - insbesondere epoxygruppenfreie - (Meth)acrylat-Monomere und andere copolymerisierbare Vinylmonomere einsetzbar, die mit (Co)Monomeren (a) und gegebenenfalls vorhandenen Comonomeren (c) und/oder (d) copolymerisierbar sind und die eine Glasübergangstemperatur als hypothetisches Homopolymer (in diesem Zusammenhang ist die Glasübergangstemperatur des Homopolymeren aus den entsprechenden Monomeren im molmassenunabhängigen Glasübergangstemperaturbereich, $T_G^{\infty}$, gemeint) von mindestens 25 °C, insbesondere mindestens 50 °C. Solche Monomere werden im Rahmen dieser Schrift auch als "harte Monomere" bezeichnet. Zur Auswahl solcher Comonomere kann zum Beispiel das Polymer Handbook (J. Brandrup, E. H. Immergut, E. A. Grulke (Hrsg.), 4. Aufl., 1999, J. Wiley, Hoboken, Bd. 1, Kapitel VI/193) konsultiert werden. Vorteilhaft einsetzbar sind auch sogenannte Makromere nach WO 2015/082143 A1. Bevorzugt werden Comonomere, die durch ihre chemische Bauart im Wesentlichen vor der Initiierung der Härtungsreaktion keine Reaktivität mit den Epoxid-Funktionalitäten der (Co)Monomere (a) aufweisen oder initiierend oder katalysierend in Bezug auf eine Reaktion der Epoxid-Funktionalitäten wirken oder ihre Reaktivität mit Epoxid-Funktionalitäten anderweitig unterbunden ist. Über den Anteil an Comonomeren (b) lassen sich

klebtechnische und mechanische Eigenschaften der Klebemasse einstellen. Sie machen die Klebemasse tendenziell härter.

Comonomere (c)

Comonomere (c) weisen insbesondere keine Epoxy-Gruppen auf. Im Sinne der Comonomere (c) sind alle dem Fachmann bekannten - insbesondere epoxygruppenfreie - (Meth)acrylat-Monomere und andere copolymerisierbare Vinylmonomere einsetzbar, die mit (Co)Monomeren (a) und gegebenenfalls vorhandenen Comonomeren (b) und/oder (d) copolymerisierbar sind und die eine Glasübergangstemperatur als hypothetisches Homopolymer (in diesem Zusammenhang ist die Glasübergangstemperatur des Homopolymeren aus den entsprechenden Monomeren im molmassenunabhängigen Glasübergangstemperaturbereich, $T_G^{\infty}$, gemeint) von unterhalb 25 °C, insbesondere höchstens 0 °C besitzen. Solche Monomere werden im Rahmen dieser Schrift auch als "weiche Monomere" bezeichnet. Zur Auswahl solcher Comonomere kann zum Beispiel auch zu diesem Zweck das Polymer Handbook (J. Brandrup, E. H. Immergut, E. A. Grulke (Hrsg.), 4. Aufl., 1999, J. Wiley, Hoboken, Bd. 1, Kapitel VI/193) konsultiert werden. Vorteilhaft einsetzbar sind auch sogenannte Makromere nach WO 2015/082143 A1. Bevorzugt werden Comonomere, die durch ihre chemische Bauart vor der Initiierung der Härtungsreaktion im Wesentlichen keine Reaktivität mit den Epoxid-Funktionalitäten der (Co)Monomere (a) aufweisen oder initiierend oder katalysierend in Bezug auf eine Reaktion der Epoxid-Funktionalitäten wirken oder ihre Reaktivität mit Epoxid-Funktionalitäten anderweitig unterbunden ist.
Über den Anteil an Comonomeren (c) lassen sich klebtechnische und mechanische Eigenschaften der Klebemasse einstellen. Sie machen die Klebemasse tendenziell weicher und es kann Haftklebrigkeit realisiert werden.

Comonomere (d)

Im Sinne der Comonomere (d) kommen insbesondere solche Monomere zum Einsatz, die mit (Co)Monomeren (a) und gegebenenfalls vorhandenen Comonomeren (b) und/oder (c) copolymerisierbar sind und die die adhäsiven Eigenschaften des erfindungsgemäßen Copolymers optimieren. In diesem Zusammenhang sind insbesondere Silizium-haltige Comonomere und hier acrylierte oder methacrylierte Alkoxysilan-haltige Comonomere als vorteilhaft zu nennen. Beispiele sind 3-(Triethoxysilyl)propylmethacrylat, 3-(Triethoxysilyl)propylacrylat, 3-(Trimethoxysilyl)propylacrylat, 3-(Trimethoxysilyl)propylmethacrylat, Methacryloxymethyltriethoxysilan, (Methacryloxymethyl)trimethoxysilan, (3-Acryloxypropyl)methyldimethoxysilan, (Methacryloxymethyl)methyldimethoxysilan, γ-Methacryloxypropylmethyldimethoxysilan, Methacryloxypropylmethyldiethoxysilan, 3-(Dimethoxymethylsilyl)propylmethacrylat, Methacryloxypropyldimethylethoxysilan, Methacryloxypropyldimethylmethoxysilan. Von den vorgenannten Verbindungen sind 3-(Triethoxysilyl)propylmethacrylat, 3-(Triethoxysilyl)propylacrylat, 3-(Trimethoxysilyl)propylacrylat und 3-(Trimethoxysilyl)propylmethacrylat besonders bevorzugt.
Auch die Comonomere (d) weisen bevorzugt keine Epoxy-Gruppen auf.

*Herstellung*

Die Herstellung der (Co)Polymere (A) erfolgt durch (Co)Polymerisation der zugrundeliegenden (Co)Monomere und kann in Substanz, in Gegenwart eines oder mehrerer organischer Lösungsmittel, in Gegenwart von Wasser oder in Gemischen aus organischen Lösungsmitteln und Wasser durchgeführt werden. Es wird dabei angestrebt, die verwendete Lösungsmittelmenge so gering wie möglich zu halten. Geeignete organische Lösungsmittel sind reine Alkane (zum Beispiel Hexan, Heptan, Octan, Isooctan, Isohexan, Cyclohexan), aromatische Kohlenwasserstoffe (zum Beispiel Benzol, Toluol, Xylol), Ester (zum Beispiel Essigsäureethylester, Essigsäurepropyl-, -butyl- oder - hexylester), halogenierte Kohlenwasserstoffe (zum Beispiel Chlorbenzol), Alkanole (zum Beispiel Methanol, Ethanol, Ethylenglycol, Ethylenglycolmonomethylether), Ketone (zum Beispiel Aceton, Butanon) und Ether (zum Beispiel Diethylether, Dibutylether) oder Gemische davon. Es wird auf Verbindungen verzichtet, die mit Epoxid-Funktionalitäten vor der Initiierung der Härtungsreaktion reagieren können oder die Reaktion von Epoxid-Funktionalitäten initiieren oder katalysieren können oder deren Reaktivität mit Epoxid-Funktionalitäten nicht anderweitig unterbunden ist.
Die wässrigen Polymerisationsreaktionen können mit einem mit Wasser mischbaren oder hydrophilen Colösungsmittel versetzt werden, um zu gewährleisten, dass das Reaktionsgemisch während des Monomerumsatzes in Form einer homogenen Phase vorliegt. Vorteilhaft verwendbare Colösungsmittel für die vorliegende Erfindung werden gewählt aus der folgenden Gruppe, bestehend aus aliphatischen Alkoholen, Glycolen, Ethern, Glycolethern, Polyethylenglycolen, Polypropylenglycolen, Estern, Alkoholderivaten, Hydroxyetherderivaten, Ketonen und dergleichen, sowie Derivaten und Gemischen davon. Es wird auf Verbindungen verzichtet, die mit Epoxid-Funktionalitäten reagieren können und/oder die die Reaktion von Epoxid-Funktionalitäten initiieren oder katalysieren können und/oder deren Reaktivität mit Epoxid-Funktionalitäten nicht anderweitig unterbunden ist.
Zur Herstellung der erfindungsgemäßen funktionalisierten (Co)Polymere werden vorteilhaft konventionelle

radikalische Polymerisationen oder kontrollierte radikalische Polymerisationen durchgeführt. Für die radikalisch verlaufenden Polymerisationen werden bevorzugt Initiatorsysteme eingesetzt, die zusätzlich weitere radikalische Initiatoren zur Polymerisation (Polymerisationsinitiatoren) enthalten, insbesondere thermisch zerfallende radikalbildende Azo- oder Peroxoinitiatoren. Prinzipiell eignen sich jedoch alle für Acrylate und/oder Methacrylate dem Fachmann geläufigen, üblichen Polymerisationsinitiatoren. Die Produktion von C-zentrierten Radikalen ist im Houben-Weyl, Methoden der Organischen Chemie, Vol. E 19a, S. 60-147, beschrieben. Diese Methoden werden in bevorzugter Weise in Analogie angewendet.
Die im Zusammenhang mit der Herstellung der (Co)polymere (A) genannten radikalischen Polymerisationsinitiatoren sind nicht zu verwechseln mit den für die Härtung der härtbaren Klebemasse zum Einsatz kommenden Härtern beziehungsweise Aktivatoren.

Beispiele für Radikalquellen sind Peroxide, Hydroperoxide und Azoverbindungen. Als einige nicht ausschließliche Beispiele für typische Radikalinitiatoren seien hier genannt Kaliumperoxodisulfat, Dibenzoylperoxid, Cumolhydroperoxid, Cyclohexanonperoxid, Ditert-butylperoxid, Azobisiisobutyronitril, Cyclohexylsulfonylacetylperoxid, Diisopropylpercarbonat, tert-Butylperoktoat, Benzpinacol. Besonders bevorzugt wird als radikalischer Polymerisationsinitiator 2,2'-Azobis(2-methylbutyronitril) oder 2,2-Azobis-(2,4-dimethylvaleronitril) verwendet.

Die Polymerisationszeit beträgt - je Temperatur und gewünschtem Umsatz - zwischen 4 und 72 Stunden. Je höher die Reaktionstemperatur gewählt werden kann, das heißt, je höher die thermische Stabilität des Reaktionsgemisches ist, desto geringer kann die Reaktionsdauer gewählt werden.

Zur Initiierung der Polymerisation ist für die thermisch zerfallenden Polymerisationsinitiatoren der Eintrag von Wärme essentiell. Die Polymerisation kann für die thermisch zerfallenden Polymerisationsinitiatoren durch Erwärmen auf 50 °C oder mehr, je nach Initiatortyp, initiiert werden. Bevorzugt wird eine Initiierungstemperatur von höchstens 100 °C, sehr bevorzugt von höchstens 80 °C.

Zur Radikalstabilisierung werden in günstiger Vorgehensweise Nitroxide eingesetzt, wie zum Beispiel (2,2,5,5-Tetramethyl-1-pyrrolidinyl)oxyl (PROXYL), (2,2,6,6-Tetramethyl-1-piperidinyl)oxyl (TEMPO), Derivate des PROXYLs oder des TEMPOs und weitere dem Fachmann geläufige Nitroxide.

Eine Reihe weiterer Polymerisationsmethoden, nach denen die Klebemassen in alternativer Vorgehensweise hergestellt werden können, lassen sich aus dem Stand der Technik wählen: WO 96/24620 A1 beschreibt ein Polymerisationsverfahren, bei dem sehr spezielle Radikalverbindungen wie zum Beispiel phosphorhaltige Nitroxide, die auf Imidazolidin basieren, eingesetzt werden. WO 98/44008 A1 offenbart spezielle Nitroxyle, die auf Morpholinen, Piperazinonen und Piperazindionen basieren. DE 199 49 352 A1 beschreibt heterocyclische Alkoxyamine als Regulatoren in kontrolliert radikalischen Polymerisationen.

Als weitere kontrollierte Polymerisationsmethode lässt sich die Atom Transfer Radical Polymerization (ATRP) einsetzen, wobei als Polymerisationsinitiatoren bevorzugt monofunktionelle oder difunktionelle sekundäre oder tertiäre Halogenide und zur Abstraktion des(r) Halogenids(e) Cu-, Ni-, Fe-, Pd-, Pt-, Ru-, Os-, Rh-, Co-, Ir-, Ag- oder Au-Komplexe eingesetzt werden. Die unterschiedlichen Möglichkeiten der ATRP sind ferner in den Schriften der US 5,945,491 A, der US 5,854,364 A und der US 5,789,487 A beschrieben.

Als weiterer Herstellprozess wird eine Variante der RAFT-Polymerisation (reversible addition-fragmentation chain transfer polymerization) durchgeführt. Der Polymerisationsprozess ist zum Beispiel in den Schriften WO 98/01478 A1 und WO 99/31144 A1 ausführlich beschrieben. Zur Herstellung eignen sich besonders vorteilhaft Trithiocarbonate der allgemeinen Struktur R'''-S-C(S)-S-R''' (Macromolecules, 2000, 33, 243-245).

In einer sehr vorteilhaften Variante werden beispielsweise die Trithiocarbonate (TTC1) und (TTC2) oder die Thioverbindungen (THI1) und (THI2) zur Polymerisation eingesetzt, wobei Φ ein Phenylring, der unfunktionalisiert oder durch Alkyl- oder Arylsubstituenten, die direkt oder über Ester- oder Etherbrücken verknüpft sind, funktionalisiert sein kann, eine Cyanogruppe oder ein gesättigter oder ungesättigter aliphatischer Rest sein kann. Der Phenylring Φ kann optional einen oder mehrere Polymerblöcke, beispielsweise Polybutadien, Polyisopren oder Polystyrol tragen, um nur einige zu nennen. Funktionalisierungen können beispielsweise Halogene, Hydroxygruppen, Epoxidgruppen sein, ohne dass diese Aufzählung Anspruch auf Vollständigkeit erhebt.

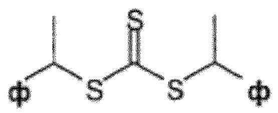
(TTC 1)

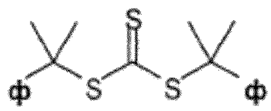
(TTC 2)

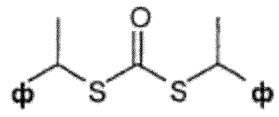

(THI 1)

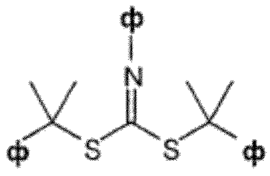

(THI 2)

In Verbindung mit den oben genannten kontrolliert radikalisch verlaufenden Polymerisationen werden Polymerisationsinitiatorsysteme bevorzugt, die zusätzlich weitere radikalische Polymerisationsinitiatoren enthalten, insbesondere die schon zuvor aufgezählten thermisch zerfallenden radikalbildenden Azo- oder Peroxoinitiatoren. Prinzipiell eignen sich hierfür jedoch alle für Acrylate und/oder Methacrylate bekannten üblichen Polymerisationsinitiatoren. Weiterhin können auch Radikalquellen verwendet werden, die erst unter UV-Bestrahlung Radikale freisetzen. Maßgeblich ist, dass diese Polymerisationsinitiatoren keine Reaktion der Epoxid-Funktionalitäten aktivieren können. Zum Zwecke der Molmasseneinstellung können auch Kettenübertragungsreagenzien nach dem Stand der Technik verwendet werden, sofern sie keine Reaktivität gegenüber Epoxidgruppen aufweisen oder ihre Reaktivität mit Epoxidgruppen anderweitig unterbunden ist.

Die gewünschte Molmasse wird bevorzugt durch Polymerisationsverfahren, seien es kontrollierte Polymerisationsverfahren oder nicht kontrollierte Polymerisationsverfahren, eingestellt, bei denen keine Mittel eingesetzt werden, die vor der Initiierung der Härtungsreaktion des Klebefilms mit Epoxid-Funktionalitäten reagieren können oder die Reaktion von Epoxid-Funktionalitäten initiieren oder katalysieren können oder ihre Reaktivität mit Epoxidgruppen anderweitig unterbunden ist.

Die Einstellung der gewünschten Molmasse kann zudem und zwar besonders bevorzugt über das Einsatzverhältnis von Polymerisationsinitiatoren und (Co)Monomer(en) und/oder die Konzentration an (Co)Monomeren realisiert werden.

Härter (B)

Die Klebemassen enthalten zumindest eine Sorte eines Härters. Die Härter werden so ausgewählt, dass die resultierende Formulierung Latenz in ihrer Reaktivität aufweist. D. h. dass das Klebesystem bzw. der auf ihm basierende Klebefilm unter bestimmten Bedingungen wie zum Beispiel bei Raumtemperatur oder auch leicht erhöhten Temperaturen wie 35 °C oder sogar 50 °C und / oder Lichtausschluss im Wesentlichen keine oder sogar gar keine Reaktion zeigt. Die Reaktion folgt auf einen Aktivierungsimpuls, der durch erhöhte Temperatur und/ oder Licht (insbesondere UV-Strahlung) ausgelöst werden kann. Im Sinne dieser Erfindung wird Latenz für thermisch härtbare Klebemassen über die Aktivierungstemperatur, die über ein DSC-Experiment ermittelt werden kann, definiert (Test D2). Die so ermittelte Aktivierungstemperatur liegt für erfindungsgemäße Härter bei mindestens 60 °C, bevorzugt bei mindestens 70 °C, sehr bevorzugt bei mindestens 90 °C. Sie liegt höchstens bei 120 °C, bevorzugt bei höchstens 100 °C. Für UV-härtbare Klebemassen ist die Latenz üblicherweise sehr gut. Es ist jedoch auf Lichtausschluss bis zum Zeitpunkt der Aktivierung zu achten.

Als Beispiele für in diesem Sinne besonders geeignete Härter seien thermisch aktivierbare Säurebildner, TAG, genannt. Durch Wärmeeinfluss wird aus der Initiatorsubstanz eine starke Säure, die sogenannte Supersäure, gebildet, die eine Ringöffnung der Epoxid-Gruppen bewirken kann. Im Sinne der vorliegenden Erfindung einsetzbare thermisch aktivierbare Härter für eine kationische Härtung von Epoxid-Gruppen sind insbesondere Pyridinium-, Ammonium- (insbesondere Anilinium-) und Sulfonium- (insbesondere Thiolanium-)-Salze sowie Lanthanoidtriflate.

Sehr vorteilhaft sind N-Benzylpyridinium-Salze und Benzylpyridinium-Salze, wobei Aromaten zum Beispiel mit Alkyl- Alkoxy-, Halogen- oder Cyano-Gruppen substituiert sein können.

J. Polym. Sci. A, 1995, 33, 505ff, US 2014/0367670 A1, US 5,242,715, J. Polym. Sci. B, 2001, 39, 2397ff, EP 393893 A1, Macromolecules, 1990, 23, 431 ff, Macromolecules, 1991, 24, 2689, Macromol. Chem. Phys., 2001, 202, 2554ff, WO 2013/156509 A2 und JP 2014/062057 A1. nennen entsprechende Verbindungen, die im Sinne dieser Erfindung einsetzbar sind.

Von den kommerziell erhältlichen Härtersystemen seien als Beispiele für sehr vorteilhaft einsetzbare Verbindungen San-Aid SI 80 L, San-Aid SI 100 L, San-Aid SI 110 L, San-Aid SI B2A, San-Aid SI B3, San-Aid SI B3A und San-Aid SI B4 der Firma Sanshin, Opton CP-66 und Opton CP-77 der Firma Adeka und K-Pure TAG 2678, K-Pure CXC 1612 und K-Pure CXC 1614 der Firma King Industries genannt.

Einsetzbar sind zudem Lanthanoidtriflate wie Samarium-III-Triflat, Ytterbium-III-Triflat, Erbium-III-Triflat oder Dysprosium-III-Triflat (erhältlich bei Sigma Aldrich) und Lanthan-III-Triflat (erhältlich bei Alfa Aesar).

Als Beispiele für Anionen, die als Gegenionen für die oben genannten Kationen dienen, seien Tetrafluoroborat, Tetraphenylborat, Hexafluorophosphat, Perchlorat, Tetrachloroferrat, Hexafluoroarsenat, Hexafluoroantimonat, Pentafluorohydroxyantimonat, Hexachloroantimonat, Tetrakispentafluorophenylborat, Tetrakis-(pentafluoromethylphenyl)-borat, Bi-(trifluoromethylsulfonyl)-amid und Tris-(trifluoromethylsulfonyl)-methid genannt. Zudem einsetzbar sind Anionen nach JP 2012-056915 A1 und EP 393893 A1. Härter, die im Wesentlichen frei von Chlor und Brom sind, werden bevorzugt. Das Anion ist bevorzugt Arsen- und Antimon-frei.

Dem Fachmann sind weitere Systeme bekannt, die ebenfalls erfindungsgemäß einsetzbar sind. Latentreaktive thermisch aktivierbare Härter für die kationische Härtung werden unkombiniert oder als Kombination von zwei oder mehreren thermisch aktivierbaren Härtern eingesetzt.

Gegenüber Photoinitiatoren und photoinitiierbaren Härtungssystemen weisen thermisch aktivierbare Initiatoren und Härtungssysteme die Vorteile auf, dass das Klebeband leichter transportier- und verarbeitbar ist. Es braucht nicht auf Lichtausschluss geachtet zu werden.

Vorteilhaft im Sinne der vorliegenden Erfindung sind latentreaktive thermisch aktivierbare Härter, die eine Aktivierungstemperatur von mindestens 60 °C, bevorzugt von mindestens 70 °C und höchstens 120 °C aufweisen, bei der eine kationische Härtung der funktionalisierten (Co)Polymere gestartet werden kann. Vorteilhafte Aktivierungs- / Härtungstemperaturen liegen auch bei 80 °C und bei 100 °C. Härtung / Initiierung in diesen Temperaturbereichen wird bevorzugt, um thermisch empfindliche (opto)elektronische Strukturen nicht thermisch zu schädigen. Die Härtungsdauer kann dabei bei 15 min oder mehr und 2 h oder weniger liegen, auch wenn deutlich kürzere (wie 10 s, 30 s, 60 s, 120 s, 240 s, 5 min oder 10 min) oder noch längere Härtungszeiten nicht ausgeschlossen sind.

Sehr bevorzugt in Kombination mit dem erfindungsgemäßen funktionalisierten (Co)Polymer sind zudem strahlenchemisch (UV) aktivierbare Säurebildner, PAG. Diese können durch UV-Initiierung eine kationische Härtungsreaktion der Epoxid-Gruppen bewirken.

Unter den Härtern für eine kationische UV-Härtung sind insbesondere Sulfonium-, Iodonium- und Metallocenbasierende Systeme einsetzbar.

Als Beispiele für Sulfonium-basierende Kationen sei auf die Ausführungen in US 6,908,722 B1 (insbesondere Spalten 10 bis 21) verwiesen.

Als Beispiele für Anionen, die als Gegenionen für die oben genannten Kationen dienen, seien Tetrafluoroborat, Tetraphenylborat, Hexafluorophosphat, Perchlorat, Tetrachloroferrat, Hexafluoroarsenat, Hexafluoroantimonat, Pentafluorohydroxyantimonat, Hexachloroantimonat, Tetrakispentafluorophenylborat, Tetrakis-(pentafluoromethylphenyl)-borat, Bi-(trifluoromethylsulfonyl)-amid und Tris-(trifluoromethylsulfonyl)-methid genannt. Ferner sind insbesondere für Iodoniumbasierende Härter auch Chlorid, Bromid oder Iodid als Anionen denkbar. Zudem einsetzbar sind Anionen nach JP 2012-056915 A1 und EP 393893 A1. Härter, die im Wesentlichen frei von Chlor und Brom sind, werden bevorzugt. Auch hier ist das Anion bevorzugt Arsen- und Antimon-frei.

Konkreter zählen zu den einsetzbaren Systemen

- Sulfonium-Salze (siehe zum Beispiel US 4,231,951 A, US 4,256,828 A, US 4,058,401 A, US 4,138,255 A und US 2010/063221 A1) wie Triphenylsulfoniumhexafluoroarsenat, Triphenylsulfoniumhexafluoroborat, Triphenylsulfoniumtetrafluoroborat, Triphenylsulfoniumtetrakis-(pentafluorobenzyl)-borat, Methyldiphenylsulfoniumtetrafluoroborat, Methyldiphenylsulfoniumtetrakis-(pentafluorobenzyl)-borat, Dimethylphenylsulfoniumhexafluorophosphat, Triphenylsulfoniumhexafluorophosphat, Triphenylsulfoniumhexafluoroantimonat, Diphenylnaphthylsulfoniumhexafluoroarsenat, Tritolylsulfoniumhexafluorophosphat, Anisyldiphenylsulfoniumhexafluoroantimonat, 4-Butoxyphenyldiphenylsulfoniumtetrafluoroborat, 4-Butoxyphenyldiphenylsulfoniumtetrakis-(pentafluorobenzyl)-borat, 4-Chlorophenyldiphenylsulfoniumhexafluoroantimonat, Tris-(4-phenoxyphenyl)-sulfoniumhexafluorophosphat, Di-(4-ethoxyphenyl)-methylsulfoniumhexafluoroarsenat, 4-Acetylphenyldiphenylsulfoniumtetrafluoroborat, 4-Acetylphenyldiphenylsulfoniumtetrakis-(pentafluorobenzyl)-borat, Tris-(4-thiomethoxyphenyl)-sulfoniumhexafluorophosphat, Di-(methoxysulfonylphenyl)-methylsulfoniumhexafluoroantimonat, Di-(methoxynaphthyl)-methylsulfoniumtetrafluoroborat, Di-(methoxynaphthyl)-methylsulfoniumtetrakis-(pentafluorobenzyl)-borat, Di-(carbomethoxyphenyl)-methylsulfoniumhexafluorophosphat, (4-Octyloxyphenyl)-diphenylsulfoniumtetrakis-(3,5-bis-trifluoromethylphenyl)-borat, Tris-[4-(4-acetylphenyl)-thiophenyl]-sulfoniumtetrakis-(pentafluorophenyl)-borat, Tris-(dodecylphenyl)-sulfoniumtetrakis-(3,5-bis-trifluoromethylphenyl)-borat, 4-Acetamidphenyldiphenylsulfoniumtetrafluoroborat, 4-Acetamidphenyldiphenylsulfoniumtetrakis-(pentafluorobenzyl)-borat, Dimethylnaphthylsulfoniumhexafluorophosphat, Trifluoromethyldiphenylsulfoniumtetrafluoroborat, Trifluoromethyldiphenylsulfoniumtetrakis-(pentafluorobenzyl)-borat, Phenylmethylbenzylsulfoniumhexafluorophosphat, 5-Methylthianthreniumhexafluorophosphat, 10-Phenyl-9,9-dimethylthioxantheniumhexafluorophosphat, 10-Phenyl-9-oxothioxantheniumtetrafluoroborat, 10-Phenyl-9-oxothioxantheniumtetrakis-(pentafluorobenzyl)-borat, 5-Methyl-10-oxothianthreniumtetrafluoroborat, 5-Methyl-10-oxothianthreniumtetrakis-(pentafluorobenzyl)-borat und 5-Methyl-10,10-dioxothianthreniumhexafluorophosphat,
- Iodonium-Salze (siehe zum Beispiel US 3,729,313 A, US 3,741,769 A, US 4,250,053 A, US 4,394,403 A und US 2010/063221 A1) wie Diphenyliodoniumtetrafluoroborat, Di-(4-methylphenyl)-iodoniumtetrafluoroborat, Phenyl-4-methylphenyliodoniumtetrafluoroborat, Di-(4-chlorphenyl)-iodoniumhexafluorophosphat, Dinaphthyliodoniumtetrafluoroborat, Di-(4-trifluormethylphenyl)-iodoniumtetrafluoroborat, Diphenyliodoniumhexafluorophosphat, Di-(4-methylphenyl)-iodoniumhexafluorophosphat, Diphenyliodoniumhexafluoroarsenat, Di-(4-phenoxyphenyl)-iodoniumtetrafluoroborat, Phenyl-2-thienyliodoniumhexafluorophosphat, 3,5-Dimethylpyrazolyl-4-phenyliodoniumhexafluorophosphat, Diphenyliodoniumhexafluoroantimonat, 2,2'-Diphenyliodoniumtetrafluoroborat, Di-(2,4-dichlorphenyl)-iodoniumhexafluorophosphat, Di-(4-bromphenyl)-iodoniumhexafluorophosphat, Di-(4-methoxyphenyl)-iodoniumhexafluorophosphat, Di-(3-carboxyphenyl)-iodoniumhexafluorophosphat, Di-(3-methoxycarbonylphenyl)-iodoniumhexafluorophosphat, Di-(3-methoxysulfonylphenyl)-iodoniumhexafluorophosphat, Di-(4-acetamidophenyl)-iodoniumhexafluorophosphat, Di-(2-benzothienyl)-iodoniumhexafluorophosphat, Diaryliodoniumtristrifluormethylsulfonylmethid wie Diphenyliodoniumhexafluoroantimonat, Diaryliodoniumtetrakis-(pentafluorophenyl)-borat wie Diphenyliodoniumtetrakis-(pentafluorophenyl)-borat,, (4-n-Desiloxyphenyl)-phenyliodoniumhexafluoroantimonat, [4-(2-Hydroxy-n-tetradesiloxy)-phenyl]-phenyliodoniumhexafluoroantimonat, [4-(2-Hydroxy-n-tetradesiloxy)-phenyl]-phenyliodoniumtrifluorosulfonat, [4-(2-Hydroxy-n-tetradesiloxy)-phenyl]-phenyliodoniumhexafluorophosphat, [4-(2-Hydroxy-n-tetradesiloxy)-phenyl]-phenyliodoniumtetrakis-(pentafluorophenyl)-borat, Bis-(4-tert-butylphenyl)-iodoniumhexafluoroantimonat, Bis-(4-tert-butylphenyl)-iodoniumhexafluorophosphat, Bis-(4-tert-butylphenyl)-iodoniumtrifluorosulfonat, Bis-(4-tert-butylphenyl)-iodoniumtetrafluoroborat, Bis-(dodecylphenyl)-iodoniumhexafluoroantimonat, Bis-(dodecylphenyl)-iodoniumtetrafluoroborat, Bis-(dodecylphenyl)-iodoniumhexafluorophosphat, Bis-(dodecylphenyl)-iodoniumtrifluoromethylsulfonat, Di-(dodecylphenyl)-iodoniumhexafluoroantimonat, Di-(dodecylphenyl)-iodoniumtriflat, Diphenyliodoniumbisulfat, 4,4'-Dichlorodiphenyliodoniumbisulfat, 4,4'-Dibromodiphenyliodoniumbisulfat, 3,3'-Dinitrodiphenyliodoniumbisulfat, 4,4'-Dimethyldiphenyliodoniumbisulfat, 4,4'-Bissuccinimidodiphenyliodoniumbisulfat, 3-Nitrodiphenyliodoniumbisulfat, 4,4'-Dimethoxydiphenyliodoniumbisulfat, Bis-(dodecylphenyl)-iodoniumtetrakis-(pentafluorophenyl)-borat, (4-Octyloxyphenyl)-phenyliodoniumtetrakis-(3,5-bis-trifluoromethylphenyl)-borat und (Tolylcumyl)-iodoniumtetrakis-(pentafluorophenyl)-borat,
und

- Ferrocenium-Salze (siehe zum Beispiel EP 542 716 B1) wie $\eta_5$-(2,4-cyclopentadien-1-yl)-[(1,2,3,4,5,6,9)-(1-methylethyl)-benzol]-eisen.

Beispiele für kommerzialisierte Photoinitiatoren (Härter) sind Cyracure UVI-6990, Cyracure UVI-6992, Cyracure UVI-6974 und Cyracure UVI-6976 der Firma Union Carbide, Optomer SP-55, Optomer SP-150, Optomer SP-151, Optomer SP-170 und Optomer SP-172 der Firma Adeka, San-Aid SI-45L, San-Aid SI-60L, San-Aid SI-80L, San-Aid SI-100L, San-Aid SI-110L, San-Aid SI-150L und San-Aid SI-180L der Firma Sanshin Chemical, SarCat CD-1010, SarCat CD-1011 und SarCat CD-1012 der Firma Sartomer, Degacure K185 der Firma Degussa, Rhodorsil Photoinitiator 2074 der Firma Rhodia, CI-2481, CI-2624, CI-2639, CI-2064, CI-2734, CI-2855, CI-2823 und CI-2758 der Firma Nippon Soda, Omnicat 320, Omnicat 430, Omnicat 432, Omnicat 440, Omnicat 445, Omnicat 550, Omnicat 550 BL und Omnicat 650 der Firma IGM Resins, Daicat II der Firma Daicel, UVAC 1591 der Firma Daicel-Cytec, FFC 509 der Firma 3M, BBI-102, BBI-103, BBI-105, BBI-106, BBI-109, BBI-110, BBI-201, BBI, 301, BI-105, DPI-105, DPI-106, DPI-109, DPI-201, DTS-102, DTS-103, DTS-105, NDS-103, NDS-105, NDS-155, NDS-159, NDS-165, TPS-102, TPS-103, TPS-105, TPS-106, TPS-109, TPS-1000, MDS-103, MDS-105, MDS-109, MDS-205, MPI-103,, MPI-105, MPI-106, MPI-109, DS-100, DS-101, MBZ-101, MBZ-201, MBZ-301, NAI-100, NAI-101, NAI-105, NAI-106, NAI-109, NAI-1002, NAI-1003, NAI-1004, NB-101, NB-201, NDI-101, NDI-105, NDI-106, NDI-109, PAI-01, PAI-101, PAI-106, PAI-1001, PI-105, PI-106, PI-109, PYR-100, SI-101, SI-105, SI-106 und SI-109 der Firma Midori Kagaku, Kayacure PCI-204, Kayacure PCI-205, Kayacure PCI-615, Kayacure PCI-625, Kayarad 220 und Kayarad 620, PCI-061T, PCI-062T, PCI-020T, PCI-022T der Firma Nippon Kayaku, TS-01 und TS-91 der Firma Sanwa Chemical, Deuteron UV 1240 der Firma Deuteron, Tego Photocompound 1465N der Firma Evonik, UV 9380 C-D1 der Firma GE Bayer Silicones, FX 512 der Firma Cytec, Silicolease UV Cata 211 der Firma Bluestar Silicones und Irgacure 250, Irgacure 261, Irgacure 270, Irgacure PAG 103, Irgacure PAG 121, Irgacure PAG 203, Irgacure PAG 290, Irgacure CGI 725, Irgacure CGI 1380, Irgacure CGI 1907 und Irgacure GSID 26-1 der Firma BASF.

Dem Fachmann sind weitere Systeme bekannt, die ebenfalls erfindungsgemäß einsetzbar sind. Photoinitiatoren (Photohärter) werden unkombiniert oder als Kombination von zwei oder mehreren Photoinitiatoren eingesetzt.

Vorteilhaft sind Photoinitiatoren, die Absorption bei kleiner 350 nm und vorteilhaft bei größer 250 nm aufweisen. Initiatoren, die oberhalb 350 nm absorbieren, beispielsweise im Bereich violetten Lichts, sind ebenfalls einsetzbar. Sulfonium-basierende Photoinitiatoren werden besonders bevorzugt eingesetzt, da sie eine vorteilhafte UV-Absorptionscharakteristik aufweisen.

Es ist auch vorteilhaft, Initiatoren zu wählen, die sich durch beide Aktivierungsarten, durch Wärme und durch Strahlung, aktivieren lassen. Es können auch Kombinationen von thermisch und photochemisch aktivierbaren Initiatoren (Härtern) zur Anwendung kommen. Auch wenn TAG- und PAG-Systeme in Kombination mit den erfindungsgemäßen funktionalisierten (Co)Polymeren bevorzugt werden, so sind alternativ oder in Kombination auch andere Initiator- / Härtersysteme denkbar. Auch hier werden Systeme bevorzugt, die in der Formulierung Latenz aufweisen.

Als Beispiele seien latentreaktive Diamine oder multifunktionelle Amine, Dicarbonsäuren oder multifunktionelle Carbonsäuren, difunktionelle Säureanhydride oder multifunktionelle Säureanhydride, primäre Dithiole oder multifunktionelle primäre Thiole genannt. Besonders vorteilhaft im Hinblick auf Latenz sind solche Reaktionspartner, die bei Raumtemperatur fest und nicht in dem erfindungsgemäßen Polymer oder einer Mischung, die dieses Polymer enthält, im nicht erweichten Zustand löslich sind aber im erweichten Zustand löslich oder beide Schmelzen miteinander mischbar sind.

Denkbar sind auch Initiatoren / Härter, die gekapselt vorliegen und unter Wärmeeinfluss in der Filmmatrix verteilt werden und dann zur Reaktion führen können.

Weitere optionale Bestandteile (C)

Den Klebemassen können optional weitere Bestandteile zugefügt werden, die die Eigenschaften des Klebesystems wunschgemäß einstellen. In diesem Zusammenhang seien Filmbildner (C1: typischerweise bis zu 79,9 Gew.-% bezogen auf die Gesamtformulierung), Klebharze (C2: typischerweise bis zu 25 Gew.-% bezogen auf die Gesamtformulierung), niederviskose Reaktivharze (C3: typischerweise bis zu 50 Gew.-%) und Getter / Scavenger (C4: bis zu 50 Gew.-% bezogen auf die Gesamtformulierung) genannt.

(C1) Filmbildner

Als Filmbildner für Klebemassen sind thermoplastische Materialien, Elastomere und thermoplastische Elastomere geeignet. Sie werden insbesondere so ausgewählt, dass sie die Barriereeigenschaften der Klebschicht nicht beeinträchtigen, sondern bevorzugt weiter verbessern. Unpolare Materialien sind daher vorteilhaft. Zudem werden Filmbildner bevorzugt, die auch in Kombination der übrigen Bestandteile der Klebemasse die Realisierung von Klebeschichten erlauben, die einen sehr geringen Gelbwert (Test E) und hohe Transparenz (hohe Transmission: Test F1; geringen Haze: Test F2) aufweisen.

Thermoplastische Materialien sind als Filmbildner denkbar, werden aber nicht bevorzugt, wenn transparente Klebeschichten gewünscht sind. Beispiele sind semikristalline Polyolefine und Ethylen-Vinylacetat-Copolymere (EVA).

Vorteilhafter sind Elastomere. Beispielhaft seien Polyisobutylen, Polybutylen, EPDM, Styrol-Butadien-Copolymere (SBR), Naturkautschuk, Nitrilkautschuk, sowie deren (teil)hydrierte Varianten und Poly(meth)acrylate genannt.

Außerdem vorteilhaft sind thermoplastische Elastomere und hier insbesondere Block-, Stern- und/oder Pfropfcopolymere mit einer Molmasse $M_w$ (Gewichtsmittel) von 300.000 g/mol oder kleiner, bevorzugt 200.000 g/mol oder kleiner. Kleinere Molgewichte sind dabei aufgrund ihrer besseren Verarbeitbarkeit bevorzugt. Die Molgewichte sollten allerdings bevorzugt oberhalb 50 000 g/mol liegen.

Spezifische Beispiele sind Styrol-Butadien-Blockcopolymere (SBS), Styrol-Isopren-Blockcopolymere (SIS), Styrol-(Isopren/Butadien)-Blockcopolymere (SIBS) und (teil)hydrierte Varianten wie Styrol-(Ethylen/Butylen)-Blockcopolymere (SEBS), Styrol-(Ethylen/Propylen)-Blockcopolymere (SEPS, SEEPS), Styrol-(Butylen/Butyl)-Blockcopolymere (SBBS) und sehr bevorzugt Styrol-iso-Butylen-Blockcopolymere (SiBS). Diese Blockcopolymere können als lineare oder mehrarmige Struktur eingesetzt werden, als Diblockcopolymer, Triblockcopolymer oder Multiblockcopolymer sowie als Gemische verschiedender Arten.

Sehr bevorzugt werden Triblockcopolymere vom Typ Polystyrol-block-Polyisobutylenblock-Polystyrol eingesetzt. Solche Systeme sind unter den Bezeichnungen SIBStar von der Firma Kaneka und Oppanol IBS von der Firma BASF bekannt gemacht worden. Weitere vorteilhaft einsetzbare Systeme sind in EP 1 743 928 A1 beschrieben.

(C2) Klebharze

Die Klebemasse enthält optional eine oder mehrere Sorten eines Klebharzes, vorteilhaft solche, die mit dem (Co)Polymer (A) und/oder gegebenenfalls mit weiteren Bestandteilen (C1) verträglich sind.

Es ist vorteilhaft, wenn dieses Klebharz eine Klebharzerweichungstemperatur (ASTM E28) von größer 25 °C, insbesondere von größer 80 °C aufweist.

Als Klebharze (C2) können in der Klebemasse zum Beispiel partiell oder vollständig hydrierte oder disproportionierte Harze auf Basis von Kolophonium und Kolophoniumderivaten, hydrierte Polymerisate des Dicyclopentadiens, partiell, selektiv oder vollständig hydrierte Kohlenwasserstoffharze auf Basis von $C_5$-, $C_5$/$C_9$- oder $C_9$-Monomerströmen, Polyterpenharze auf Basis von $\alpha$-Pinen und/oder $\beta$-Pinen und/oder $\delta$-Limonen, hydrierte Polymerisate von bevorzugt reinen $C_8$- und $C_9$-Aromaten eingesetzt werden. Vorgenannte Klebharze können sowohl allein als auch im Gemisch eingesetzt werden.

Um eine hohe Alterungs- und UV-Stabilität zu gewährleisten, sind hydrierte Harze mit einem Hydrierungsgrad von mindestens 90 %, vorzugsweise von mindestens 95 % bevorzugt.

Des Weiteren sind insbesondere in Kombination mit unpolaren Filmbildnern unpolare Harze mit einem DACP-Wert (diacetone alcohol cloud point) oberhalb von 30 °C und einem MMAP-Wert (mixed methylcyclohexane aniline point) von größer 50 °C, insbesondere mit einem DACP-Wert oberhalb von 37 °C und einem MMAP-Wert größer 60 °C bevorzugt. Der DACP-Wert und der MMAP-Wert geben jeweils die Löslichkeit in einem bestimmten Lösemittelgemisch

an (siehe hierzu C. Donker, PSTC Annual Technical Seminar Proceedings, Mai 2001, S. 149-164). Durch die Auswahl dieser Bereiche wird eine besonders hohe Permeationsbarriere, insbesondere gegen Wasserdampf, erreicht. (Teil)hydrierte Kohlenwasserstoffharze kommen bevorzugt nur dann zum Einsatz, wenn die Formulierung noch zumindest einen unpolaren, insbesondere Kohlenwasserstoffbasierenden Filmbildner (C1) enthält.

(C3) niederviskose Reaktivharze

Optional aber vorteilhaft können Reaktivharze eingesetzt werden. Sie kommen bevorzugt zu einem Anteil in der Gesamtformulierung von höchstens 50 Gew.-%, bevorzugt von höchstens 25 Gew.-%, sehr bevorzugt von höchstens 10 Gew.-% zum Einsatz. Bei diesen niederviskosen Reaktivharzen handelt es sich insbesondere um cyclische Ether, also Verbindungen, die zumindest eine Oxiran-Gruppe tragen, oder Oxetane. Sie können aromatischer oder insbesondere aliphatischer oder cycloaliphatischer Natur sein. Einsetzbare Reaktivharze können monofunktionell, difunktionell, trifunktionell, tetrafunktionell oder höher funktionell bis zu polyfunktionell gestaltet sein, wobei sich die Funktionalität auf die cyclische Ethergruppe bezieht.

Beispiele, ohne sich einschränken zu wollen, sind 3,4-Epoxycyclohexylmethyl-3',4'-epoxycyclohexancarboxylat (EEC) und Derivate, Dicyclopendadiendioxid und Derivate, 3-Ethyl-3-oxetanmethanol und Derivate, Tetrahydrophthalsäurediglycidylester und Derivate, Hexahydrophthalsäurediglycidylester und Derivate, 1,2-Ethandiglycidylether und Derivate, 1,3-Propandiglycidylether und Derivate, 1,4-Butandioldiglycidylether und Derivate, höhere 1,n-Alkandiglycidylether und Derivate, Bis-[(3,4-epoxycyclohexyl)methyl]-adipat und Derivate, Vinylcyclohexyldioxid und Derivate, 1,4-Cyclohexandimethanol-bis-(3,4-epoxycyclohexancarboxylat) und Derivate, 4,5-Epoxytetrahydrophthalsäurediglycidylester und Derivate, Bis-[1-ethyl(3-oxetanyl)methyl)ether und Derivate, Pentaerythritoltetraglycidylether und Derivate, Bisphenol-A-Digylcidylether (DGEBA), hydriertes Bisphenol-A-Diglycidylether, Bisphenol-F-Diglycidylether, hydriertes Bisphenol-F-Diglycidylether, Epoxyphenol-Novolaks, hydrierte Epoxyphenol-Novolaks, Epoxycresol-Novolaks, hydrierte Epoxycresol-Novolaks, 2-(7-Oxabicyclospiro(1,3-dioxan-5,3'-(7-oxabicyclo[4.1.0]-heptan)), 1,4-Bis((2,3-epoxypropoxy)methyl)cyclohexan. Auch hier werden (cyclo)aliphatische Epoxide bevorzugt.

Reaktivharze können in ihrer monomeren oder auch dimeren, trimeren, usw. bis hin zu ihrer oligomeren Form eingesetzt werden, insbesondere sofern das gewichtsmittlere Molekulargewicht 5 000 g/mol nicht erreicht.

Gemische von Reaktivharzen untereinander aber auch mit anderen coreaktiven Verbindungen wie Alkoholen (monofunktionell oder mehrfach funktionell) oder Vinylethern (monofunktionell oder mehrfach funktionell) sind ebenfalls möglich.

(C4) optionale Getter / Scavenger

In einer weiteren vorteilhaften Ausführung der vorliegenden Erfindung werden auch Füllstoffe, die mit Sauerstoff und/oder Wasserdampf in besonderer Weise wechselwirken können, eingesetzt. In die (opto-)elektronische Anordnung eindringender Sauerstoff oder Wasserdampf wird dann an diesen Füllstoffen chemisch oder physikalisch gebunden. Diese Füllstoffe werden auch als "getter", "scavenger", "desiccants" oder "absorber" bezeichnet. Solche Füllstoffe umfassen beispielhaft, aber nicht einschränkend oxidierbare Metalle, Halide, Salze, Silicate, Oxide, Hydroxide, Sulfate, Sulfite, Carbonate von Metallen und Übergangsmetallen, Perchlorate und aktivierten Kohlenstoff, einschließlich seiner Modifikationen. Beispiele sind Cobaltchlorid, Calciumchlorid, Calciumbromid, Lithiumchlorid, Zinkchlorid, Zinkbromid, Siliciumdioxid (Silica Gel), Aluminiumoxid (aktiviertes Aluminium), Calciumsulfat, Kupfersulfat, Natriumdithionit, Natriumcarbonat, Magnesiumcarbonat, Titandioxid, Bentonit, Montmorillonit, Diatomenerde, Zeolithe und Oxide von (Erd)Alkalimetallen, wie Bariumoxid, Calciumoxid, Eisenoxid und Magesiumoxid oder auch Kohlenstoffnanoröhrchen. Des Weiteren können auch organische Absorber wie beispielsweise Polyolefin-Copolymere, Polyamid-Copolymere, PET-Copolyester oder weitere auf Hybridpolymeren basierte Absorber, die meist in Kombination mit Katalysatoren wie beispielsweise Cobalt verwendet werden, eingesetzt werden. Weitere organische Absorber sind etwa schwach vernetzte Polyacrylsäure, Ascorbate, Glucose, Gallussäure oder ungesättigte Fette und Öle. Es werden halogenfreie Systeme bevorzugt.

In einer Erfindungsauslegung, um eine möglichst gute Wirksamkeit der Getter / Scavanger hinsichtlich der Barrierewirkung zu erzielen, sollte der Getteranteil nicht zu gering sein. Der Anteil beträgt vorzugsweise mindestens 5 Gew.-%, weiter bevorzugt mindestens 10 Gew.-% und ganz bevorzugt mindestens 15 Gew.-%. Typischerweise wird ein möglichst hoher Anteil von Gettern eingesetzt, ohne dabei die Klebkräfte der Klebemasse zu stark herabzusetzen oder weitere Eigenschaften zu beeinträchtigen. Je nach Gettertyp können Getteranteile von bis zu 50 Gew.-% eingesetzt werden.

Als weitere optionale Bestandteile (C) können als Additive der Klebemasse übliche Zuschlagstoffe wie Alterungsschutzmittel (Antiozonantien, Antioxidantien, Lichtschutzmittel usw.) zugesetzt sein.

Als mögliche Additive des Klebesystems seien folgende genannt:

- primäre Antioxidantien wie zum Beispiel sterisch gehinderte Phenole
- sekundäre Antioxidantien wie zum Beispiel Phosphite oder Thioether
- Prozessstabilisatoren wie zum Beispiel C-Radikalfänger
- Lichtschutzmittel wie zum Beispiel UV-Absorber oder sterisch gehinderte Amine
- Verarbeitungshilfsmittel
- Netzadditive
- Verträglichkeitsvermittler
- Haftvermittler
- Farbmittel / Pigmente

Die Zuschlagstoffe oder Additive sind nicht zwingend, ein Vorteil der erfindungsgemäßen Klebemasse ist, dass diese ihre vorteilhaften Eigenschaften aufweist, auch ohne dass zusätzliche Additive einzeln oder in beliebiger Kombination zugesetzt sind. Dennoch kann es im Einzelnen vorteilhaft und wünschenswert sein, bestimmte weitere Eigenschaften der Klebemasse durch Additivzugabe zu justieren.
So lässt sich beispielsweise die Transparenz der Masse und deren Farbe beeinflussen. Manche Formulierungen sind optisch klar, andere opak, wieder andere farbig, schwarz, weiß oder grau eingestellt.

Auch unter den optionalen Zuschlagsstoffen / Additiven werden solche ausgewählt, die vor der Initiierung der Härtungsreaktion im Wesentlichen keine oder insbesondere gar keine Reaktion mit Epoxid-Funktionalitäten eingehen oder die Reaktionen der Epoxid-Funktionalitäten weder initiieren noch katalysieren, oder solche, bei denen die Reaktivität mit Epoxid-Funktionalitäten anderweitig unterbunden ist.

In Kombination mit Comonomeren (d) auf Silan-Basis, sofern solche zum Einsatz kommen, oder auch alternativ können als Haftvermittler weitere Silane verwendet werden, die nicht durch Polymerisation in die erfindungsgemäßen funktionalisierten (Co)Polymere (A) eingebaut sind.

Im Sinne dieser Erfindung einsetzbare Beispiele für Silane sind, ohne sich einschränken zu wollen, Methyltrimethoxysilan, Methyltriethoxysilan, Dimethyldimethoxysilan, Dimethyldiethoxysilan, Trimethylethoxysilan, Ethyltrimethoxysilan, Propyltrimethoxysilan, Propyltriethoxysilan, iso-Butyltrimethoxysilan, iso-Butyltriethoxysilan, Octyltrimethoxysilan, Octyltriethoxysilan, iso-Octyltrimethoxysilan, iso-Octyltriethoxysilan, Hexadecyltrimethoxysilan, Hexadecyltriethoxysilan, Octadecylmethyldimethoxysilan, Phenyltrimethoxysilan, Phenyltriethoxysilan, Cyclohexylmethyldimethoxysilan, Dicyclopentyldimethoxysilan.

Ein Beispiel für silylfunktionalisierte Oligomere oder Polymere, die erfindungsgemäß zum Einsatz kommen können, ist Polyethylenglykol, das mit einer Trimethoxysilan-Gruppe verknüpft ist.

Weitere Beispiele für einsetzbare Silane, die zumindest eine Funktionalisierung tragen, sind, Vinyltrimethoxysilan, Vinyltriethoxysilan, Vinyl-tri(2-methoxyethoxy)-silan, Vinyltriisopropoxysilan, Vinyldimethoxymethylsilan, Vinyltriacetoxysilan, 3-Glycidyloxypropyltrimethoxysilan, 3-Glycidyloxypropyltriethoxysilan, 2-(3,4-Epoxycyclohexyl)-ethyltriethoxysilan, 3-Glycidyloxypropyldiethoxymethylsilan, 3-Methacryloyloxypropyltrimethoxysilan, 3-Methacryloyloxypropyltriethoxysilan, 3-Methacryloyloxypropyltriisopropoxysilan, 3-Methacryloyloxypropyldimethoxymethylsilan, 3-Methacryloyloxypropyldiethoxymethylsilan, 3-Chloropropyltrimethoxysilan, 3-Chloropropyltriethoxysilan, 3-Ureidopropyltrimethoxysilan, 3-Ureidopropyltriethoxysilan, 2-Hydroxy-4-(3-triethoxysilylpropoxy)-benzophenon, 4-(3'-Chlorodimethylsilylpropoxy)-benzophenon.

Füllstoffe können in den Klebemassen eingesetzt werden. Bevorzugt werden als Füllstoffe der Klebmasse nanoskalige und/oder transparente Füllstoffe verwendet. Als nanoskalig wird ein Füllstoff vorliegend bezeichnet, wenn er in mindestens einer Dimension eine maximale Ausdehnung von 100 nm, bevorzugt von 10 nm, aufweist. Besonders bevorzugt werden solche in der Masse transparente Füllstoffe mit plättchenförmiger Kristallitstruktur und einem hohen Aspektverhältnis bei homogener Verteilung verwendet. Die Füllstoffe mit plättchenartiger Kristallitstruktur und Aspektverhältnissen weit über 100 haben in der Regel nur eine Dicke von einigen nm, die Länge beziehungsweise die Breite der Kristallite kann aber bis zu einigen μm betragen. Derartige Füllstoffe werden ebenfalls als Nanopartikel bezeichnet. Die partikuläre Ausgestaltung der Füllstoffe mit kleinen Abmessungen ist zudem besonders vorteilhaft für eine transparente Auslegung der Klebemasse.

Durch den Aufbau labyrinthartiger Strukturen mithilfe der zuvor beschriebenen Füllstoffe in der Klebstoffmatrix wird der Diffusionsweg von zum Beispiel Sauerstoff und Wasserdampf derartig verlängert, dass ihre Permeation durch die Klebstoffschicht hindurch vermindert wird. Zur besseren Dispergierbarkeit dieser Füllstoffe in der Bindemittelmatrix können diese Füllstoffe mit organischen Verbindungen oberflächlich modifiziert werden. Der Einsatz derartiger Füllstoffe an sich ist beispielsweise aus der US 2007/0135552 A1 sowie der WO 02/026908 A1 bekannt.

Des Weiteren ist eine möglichst feine Verteilung und möglichst hohe Oberfläche der Füllstoffe vorteilhaft. Dies ermöglicht einen höheren Wirkungsgrad und eine höhere Beladungskapazität und wird insbesondere mit nanoskaligen Füllstoffen erreicht.

Die Füllstoffe sind nicht zwingend, die Klebemasse funktioniert auch, ohne dass diese einzeln oder in beliebiger Kombination zugesetzt sind. Auch unter den optionalen Füllstoffen / Gettern / Scavengern werden solche ausgewählt,

die vor der Initiierung des Härtungsprozesses im Wesentlichen keine oder insbesondere gar keine Reaktion mit Epoxid-Funktionalitäten eingehen oder keine Reaktionen der Epoxid-Funktionalitäten initiieren oder katalysieren oder die Reaktivität mit Epoxid-Funktionalitäten anderweitig unterbunden ist.

Produktaufbauten

Besonders vorteilhaft lässt sich die Klebemasse in einem ein- oder doppelseitig klebenden Klebeband wie beansprucht verwenden. Diese Darreichungsart erlaubt eine besonders einfache und gleichmäßige Applikation der Klebemasse.

Der allgemeine Ausdruck "Klebeband" umfasst dabei ein Trägermaterial, welches ein- oder beidseitig mit einer Klebemasse versehen ist. Das Trägermaterial umfasst alle flächigen Gebilde, beispielsweise in zwei Dimensionen ausgedehnte Folien oder Folienabschnitte, Bänder mit ausgedehnter Länge und begrenzter Breite, Bandabschnitte, Stanzlinge (beispielsweise in Form von Umrandungen oder Begrenzungen einer (opto-)elektronischen Anordnung), Mehrschichtanordnungen und dergleichen. Dabei sind für verschiedene Anwendungen unterschiedlichste Träger wie insbesondere Folien mit den Klebmassen kombinierbar. Des Weiteren umfasst der Ausdruck "Klebeband" auch so genannte "Transferklebebänder", das heißt ein Klebeband ohne Träger. Bei einem Transferklebeband ist die Klebemasse vielmehr vor der Applikation zwischen flexiblen Linern aufgebracht, die mit einer Trennschicht versehen sind und/oder antiadhäsive Eigenschaften aufweisen. Zur Applikation wird regelmäßig zunächst ein Liner entfernt, die Klebemasse appliziert und dann der zweite Liner entfernt. Die Klebemasse kann so direkt zur Verbindung zweier Oberflächen in (opto-)elektronischen Anordnungen verwendet werden.

Es sind aber auch Klebebänder möglich, bei denen nicht mit zwei Linern sondern mit einem einzigen doppelseitig trennend ausgerüsteten Liner gearbeitet wird. Die Klebebandbahn ist dann an ihrer Oberseite mit der einen Seite eines doppelseitig trennend ausgerüsteten Liners abgedeckt, ihre Unterseite mit der Rückseite des doppelseitig trennend ausgerüsteten Liners, insbesondere einer benachbarten Windung auf einem Ballen oder einer Rolle.

Als Trägermaterial eines einseitig klebenden Klebebands werden vorliegend bevorzugt Polymerfolien, Folienverbunde oder mit organischen und/oder anorganischen Schichten versehene Folien oder Folienverbunde eingesetzt. Derartige Folien/Folienverbunde können aus allen gängigen zur Folienherstellung verwendeten Kunststoffen bestehen, beispielhaft aber nicht einschränkend erwähnt seien:

Polyethylen, Polypropylen - insbesondere das durch mono-oder biaxiale Streckung erzeugte orientierte Polypropylen (OPP), Cyclische Olefin Copolymere (COC), Polyvinylchlorid (PVC), Polyester - insbesondere Polyethylenterephthalat (PET) und Poylethylennaphtalat (PEN), Ethylenvinylalkohol (EVOH), Polyvinylidenchlorid (PVDC), Polyvinylidenfluorid (PVDF), Polyacrylnitril (PAN), Polycarbonat (PC), Polyamid (PA), Polyethersulfon (PES) oder Polyimid (PI).

Der Träger kann zudem mit organischen oder anorganischen Beschichtungen oder Schichten kombiniert sein. Dies kann durch übliche Verfahren wie zum Beispiel Lackieren, Drucken, Bedampfen, Sputtern, Co-Extrusion oder Lamination geschehen. Beispielhaft, aber nicht einschränkend erwähnt seien hier etwa Oxide oder Nitride des Siliziums und des Aluminiums, Indium-Zinn-Oxid (ITO) oder Sol-Gel-Beschichtungen.

Sehr gut als Trägerfolien sind auch solche aus Dünngläsern. Diese sind in Schichtdicken von weniger als 1 mm und sogar in 30 μm zum Beispiel. D 263 T der Firma Schott oder Willow Glass der Firma Corning verfügbar. Dünnglasfolien lassen sich durch Zulaminieren einer Kunststofffolie (zum Beispiel Polyester) mittels eines Transferklebebands, sofern gewünscht, weiter stabilisieren.

Bevorzugt werden als Dünngläser solche oder andersartige Trägermaterialien mit einer Dicke von 15 bis 200 μm, vorzugsweise 20 bis 100 μm, weiter vorzugsweise 25 bis 75, besonders vorzugsweise 30 bis 50 μm eingesetzt.

Vorteilhafterweise werden für Dünngläser ein Borosilikatglas wie D263 T eco der Firma Schott, ein Alkali-Erdalkali-Silikatglas oder ein Aluminoborosilikatglas wie AF 32 eco ebenfalls von der Firma Schott, eingesetzt. Ein alkalifreies Dünnglas wie AF32 eco ist vorteilhaft, weil die UV-Transmission höher ist. Ein alkalihaltiges Dünnglas wie D263 T eco ist vorteilhaft, weil der Wärmeausdehnungskoeffizient höher ist und besser mit den polymeren Bestandteilen des weiteren OLED-Aufbaus zusammenpasst. Derartige Gläser können im Down-Draw-Prozess, wie er in WO 00/41978 A1 referenziert ist, oder in Verfahren hergestellt werden, wie sie beispielsweise in der EP 1 832 558 A1 offenbart sind. In WO 00/41978 A1 sind weiterhin Verfahren offenbart, Verbunde aus Dünnglas und Polymerschichten oder -folien herzustellen.

Besonders bevorzugt sind diese Folien/Folienverbunde, insbesondere die Polymerfolien mit einer Permeationsbarriere für Sauerstoff und Wasserdampf versehen, wobei die Permeationsbarriere die Anforderungen für den Verpackungsbereich übertrifft (typischerweise WVTR < $10^{-1}$ g/($m^2$d) und OTR < $10^{-1}$ $cm^3$/($m^2$d bar)).

Bei Dünnglasfolien oder Dünnglasfolienverbünden ist auf Grund der intrinsisch hohen Barriereeigenschaften des Glases eine entsprechende Beschichtung nicht erforderlich. Dünnglasfolien oder Dünnglasfolienverbünde werden bevorzugt, wie in der Regel auch Polymerfolien, als Band von einer Rolle bereitgestellt. Entsprechende Gläser werden von der Firma Corning bereits unter der Bezeichung Willow Glass angeboten. Diese Lieferform lässt sich mit einer bevorzugt ebenfalls bandförmig bereitgestellten Klebemasse laminieren. Hierfür bietet sich eine haftklebrige Ausgestaltung der Klebemasse an.

Zudem können die Folien/Folienverbunde in bevorzugter Ausgestaltung transparent ausgebildet sein, damit auch der Gesamtaufbau eines derartigen Klebeartikels transparent ausgebildet ist. "Transparenz" bedeutet auch hier eine mittlere Transmission im sichtbaren Bereich des Lichts von mindestens 75 %, bevorzugt höher als 90 % (nach Test F1) und einen Haze von höchstens 5,0 %, insbesondere von höchstens 2,5 % (nach Test F2).

Bei doppelseitig klebenden härtbaren Klebebändern können als obere und untere Schicht erfindungsgemäße Klebemassen gleicher oder verschiedener Art und/oder gleicher oder verschiedener Schichtdicke zur Anwendung kommen. Der Träger kann dabei auf einer oder beiden Seiten dem Stand der Technik entsprechend vorbehandelt sein, so dass beispielsweise eine Verbesserung der Klebemassenverankerung erzielt wird. Ebenso können eine oder beide Seiten mit einer funktionalen Schicht ausgerüstet sein, die beispielsweise als Sperrschicht fungieren kann.

In einer Variante ist in dem doppelseitig klebenden härtbaren Klebeband eine erfindungsgemäße Klebemasse vorgesehen sowie eine beliebige weitere, zum Beispiel eine solche, die besonders gut auf einem Abdecksubstrat haftet oder eine besonders gute Repositionierbarkeit zeigt.

Des Weiteren ist die härtbare Klebemasse sowie ein eventuell damit gebildetes Klebeband im gehärteten Zustand hervorragend zur Kapselung einer elektronischen Anordnung gegen Permeate geeignet, indem die Klebemasse oder das Klebeband auf und/oder um die zu kapselnden Bereiche der elektronischen Anordnung appliziert und gleichzeitig oder anschließend für die Härtung aktiviert werden.

Als Kapselung wird vorliegend nicht nur ein vollumfänglicher Einschluss mit der genannten Klebemasse bezeichnet sondern auch bereits eine bereichsweise Applikation der Klebemasse auf den zu kapselnden Bereichen der (opto-)elektronischen Anordnung, beispielsweise eine einseitige Überdeckung oder eine Umrahmung einer elektronischen Struktur.

Im Prinzip können mit Klebebändern zwei Arten der Verkapselung durchgeführt werden. Entweder wird das Klebeband zuvor ausgestanzt und nur um die zu kapselnden Bereiche herum verklebt, oder es wird vollflächig über die zu kapselnden Bereiche geklebt. Ein Vorteil der zweiten Variante ist die einfachere Handhabung und der häufig bessere Schutz.

Handelt es sich bei der Klebemasse um eine Haftklebemasse, ist die Applikation besonders einfach, da keine Vorfixierung erfolgen muss. Die Haftklebemassen erlauben eine flexible und saubere Verarbeitung. Auch kann durch die Darreichung als Haftklebeband die Menge der Haftklebemasse einfach dosiert werden. Zumindest nach der Applikation auf das Zielsubstrat oder die Zielsubstrate wird die Haftklebemasse durch thermische und/oder strahlenchemische Aktivierung des latentreaktiven Initiators einer Vernetzung ausgesetzt. Dieser Prozessablauf wird auch bevorzugt.

Handelt es sich bei der Klebemasse um eine nicht haftklebrige Ausführungsform, dann erfolgt die Verklebung zum Beispiel durch Positionierung des Klebebandabschnitts auf einen Zielbereich eines ersten Substrats. Hier kann eine thermische Vorlaminierung bei einer Temperatur, der Laminiertemperatur, bei der noch keine Wesentliche Aktivierung der Härtungsreaktion der Epoxid-Gruppen stattfindet, erfolgen, so dass der Klebebandabschnitt vorfixiert wird. Anschließend wird das zweite Substrat zugeführt und unter Wärme und Druck sowie gegebenenfalls Strahlung zu einem versiegelten Klebeverbund gehärtet. Auf den vorgelagerten Vorfixierungsschritt kann auch verzichtet werden. In diesem Fall werden beide zu verklebenden Substrate und der Klebebandabschnitt zusammengeführt und dann unter Wärme und Druck sowie gegebenenfalls Strahlung zu einem versiegelten Klebeverbund gehärtet. In einem Inline-Verfahren oder wenn verschiedene Offline-Prozesse in rascher Abfolge durchgeführt werden, kann die Vorlaminiertemperatur bereits zur Aktivierung der Härtungsreaktion genutzt werden.

Zur weiteren Beschleunigung der Härtungsreaktion der aktivierten Klebemasse in einem Klebeverbund kann der Verbund nach der Aktivierung noch zusätzlich Wärme ausgesetzt werden, d. h. getempert werden.

Diese Prozesse sind an sich natürlich auch für haftklebrige Ausführungsformen durchführbar.

Weitere Einzelheiten, Ziele, Merkmale und Vorteile der vorliegenden Erfindung werden nachfolgend anhand mehrerer, bevorzugte Ausführungsbeispiele darstellende Figuren näher erläutert. Es zeigen

Fig. 1 eine erste (opto-)elektronische Anordnung in schematischer Darstellung,

Fig. 2 eine zweite (opto-)elektronische Anordnung in schematischer Darstellung,

Fig. 3 eine dritte (opto-)elektronische Anordnung in schematischer Darstellung.

Fig. 1 zeigt eine erste Ausgestaltung einer (opto-)elektronischen Anordnung 1. Diese Anordnung 1 weist ein Substrat 2 auf, auf dem eine elektronische Struktur 3 angeordnet ist. Das Substrat 2 selbst ist als Barriere für Permeate ausgebildet und bildet damit einen Teil der Kapselung der elektronischen Struktur 3. Oberhalb der elektronischen Struktur 3, vorliegend auch räumlich von dieser beabstandet, ist eine weitere als Barriere ausgebildete Abdeckung 4 angeordnet.

Um die elektronische Struktur 3 auch zur Seite hin zu kapseln und gleichzeitig die Abdeckung 4 mit der elektronischen Anordnung 1 im Übrigen zu verbinden, ist eine Klebemasse 5 umlaufend neben der elektronischen Struktur

3 auf dem Substrat 2 vorgesehen. In anderen Ausführungsformen erfolgt die Kapselung nicht mit einer reinen Klebemasse 5, sondern mit einem Klebeband 5, das zumindest eine erfindungsgemäße Klebemasse enthält. Die Klebemasse 5 verbindet die Abdeckung 4 mit dem Substrat 2. Durch eine entsprechend dicke Ausgestaltung ermöglicht die Klebemasse 5 zudem die Beabstandung der Abdeckung 4 von der elektronischen Struktur 3.

Bei der Klebemasse 5 handelt es sich um eine solche auf Basis der erfindungsgemäßen Klebemasse wie sie vorstehend in allgemeiner Form beschrieben wurde. Die Klebemasse 5 übernimmt vorliegend nicht nur die Funktion des Verbindens des Substrats 2 mit der Abdeckung 4 sondern bildet zudem auch eine Barriereschicht für Permeate bereit, um so die elektronische Struktur 2 auch von der Seite gegen Permeate wie Wasserdampf und Sauerstoff zu kapseln. Sie wird als härtbare Klebemasse appliziert und übernimmt die finale Verbindungsfunktion nach Aktivierung im gehärteten Zustand.

Die Klebemasse 5 wird vorliegend zudem in Form eines Stanzlings aus einem doppelseitigen Klebeband bereitgestellt. Ein derartiger Stanzling ermöglicht eine besonders einfache Applikation.

Fig. 2 zeigt eine alternative Ausgestaltung einer (opto-)elektronischen Anordnung 1. Gezeigt ist wiederum eine elektronische Struktur 3, die auf einem Substrat 2 angeordnet und durch das Substrat 2 von unten gekapselt ist. Oberhalb und seitlich von der elektronischen Struktur ist nun die Klebemasse 5 vollflächig angeordnet. Die elektronische Struktur 3 wird somit von oben vollständig durch die Klebemasse 5 gekapselt. Auf die Klebemasse 5 ist sodann eine Abdeckung 4 aufgebracht. Diese Abdeckung 4 muss im Gegensatz zu der vorherigen Ausgestaltung nicht zwingend die hohen Barriereanforderungen erfüllen, da die Barriere bereits durch die Klebemasse bereitgestellt wird. Die Abdeckung 4 kann beispielsweise lediglich eine mechanische Schutzfunktion wahrnehmen, sie kann aber auch zusätzlich als Permeationsbarriere vorgesehen sein.

Fig. 3 zeigt eine weitere alternative Ausgestaltung einer (opto-)elektronischen Anordnung 1. Im Gegensatz zu den vorherigen Ausgestaltungen sind nun zwei Klebemassen 5a, 5b vorgesehen, die vorliegend identisch ausgebildet sind. Die erste Klebemasse 5a ist vollflächig auf dem Substrat 2 angeordnet. Auf der Klebemasse 5a ist die elektronische Struktur 3 vorgesehen, die durch die Klebemasse 5a fixiert wird. Der Verbund aus Klebemasse 5a und elektronischer Struktur 3 wird dann mit der weiteren Klebemasse 5b vollflächig überdeckt, so dass die elektronische Struktur 3 von allen Seiten durch die Klebemassen 5a, b gekapselt ist. Oberhalb der Klebemasse 5b ist wiederum die Abdeckung 4 vorgesehen.

In dieser Ausgestaltung müssen somit weder das Substrat 2 noch die Abdeckung 4 zwingend Barriereeigenschaften aufweisen. Sie können aber dennoch vorgesehen sein, um die Permeation von Permeaten zur elektronischen Struktur 3 weiter einzuschränken.

Insbesondere im Hinblick auf die Fig. 2, 3 wird darauf hingewiesen, dass es sich vorliegend um schematische Darstellungen handelt. Aus den Darstellungen ist insbesondere nicht ersichtlich, dass die Klebemasse 5 hier und vorzugsweise jeweils mit einer homogenen Schichtdicke aufgetragen wird. Am Übergang zur elektronischen Struktur bildet sich daher keine scharfe Kante, wie es in der Darstellung scheint, sondern der Übergang ist fließend und es können vielmehr kleine un- oder gasgefüllte Bereiche verbleiben. Gegebenenfalls kann jedoch auch eine Anpassung an den Untergrund erfolgen, insbesondere dann, wenn die Applikation unter Vakuum oder unter erhöhtem Druck durchgeführt wird. Zudem wird die Klebemasse lokal unterschiedlich stark komprimiert, so dass durch Fließprozesse insbesondere auch bei erhöhter Temperatur ein gewisser Ausgleich der Höhendifferenz an den Kantenstrukturen erfolgen kann. Auch die gezeigten Dimensionen sind nicht maßstäblich, sondern dienen vielmehr nur einer besseren Darstellung. Insbesondere die elektronische Struktur selbst ist in der Regel relativ flach ausgebildet (oft weniger als 1 μm dick).

Die Applikation der Klebemasse 5 erfolgt in allen gezeigten Ausführungsbeispielen in Form eines Klebebandes. Dabei kann es sich grundsätzlich um ein doppelseitiges Klebeband mit einem Träger oder um ein Transferklebeband handeln. Vorliegend ist eine Ausgestaltung als Transferklebeband gewählt.

Die Dicke der Klebemasse, die entweder als Transferklebeband oder auf einem flächigen Gebilde beschichtet vorliegt, beträgt bevorzugt zwischen 1 μm und 150 μm, weiter bevorzugt zwischen 5 μm und 75 μm und besonders bevorzugt zwischen 12 μm und 50 μm. Hohe Schichtdicken zwischen 50 μm und 150 μm werden dann eingesetzt, wenn eine verbesserte Haftung auf dem Substrat und/oder eine dämpfende Wirkung innerhalb des (opto-)elektronischen Aufbaus erreicht werden soll. Nachteilig ist hier jedoch der erhöhte Permeationsquerschnitt. Geringe Schichtdicken zwischen 1 μm und 12 μm reduzieren den Permeationsquerschnitt, damit die laterale Permeation und die Gesamtdicke des (opto-)elektronischen Aufbaus. Jedoch kommt es zu einer Verringerung der Haftung aus dem Substrat. In den besonders bevorzugten Dickenbereichen liegt ein guter Kompromiss zwischen einer geringen Massendicke und dem daraus folgenden niedrigen Permeationsquerschnitt, der die laterale Permeation verringert, und einem genügend dicken Massefilm zur Herstellung einer ausreichend haftenden Verbindung vor. Die optimale Dicke hängt vom (opto-)elektronischen Aufbau, der Endanwendung, der Art der Ausführung der Klebemasse und gegebenenfalls dem flächigen Substrat ab.

Für doppelseitige Klebebänder gilt für die Barriereklebemasse(n) ebenfalls, dass die Dicke der einzelnen Klebemasseschicht(en) bevorzugt zwischen 1 μm und 150 μm, weiter bevorzugt zwischen 5 μm und 75 μm und besonders bevorzugt zwischen 12 μm und 50 μm liegt. Kommt in doppelseitigen Klebebändern neben der einen erfindungsgemäßen

Barriereklebemasse eine weitere zum Einsatz, dann kann es auch vorteilhaft sein, wenn ihre Dicke oberhalb 150 μm liegt.

Ein geeignetes Verfahren zur Verklebung der Klebeprodukte mit den erfindungsgemäßen Klebemassen beinhaltet die Befreiung der ersten Klebeoberfläche von einer Schutzlinerschicht und der Lamination des Klebeprodukts auf ein erstes Zielsubstrat. Dies kann durch Kaschierung mittels (Gummi-)walzen oder auch in Pressen erfolgen. Hierbei kann eine erhöhte Temperatur zum Einsatz kommen. Durch etwaige Haftklebrigkeit ist ein besonders hoher Druck beim Laminieren nicht in jedem Fall erforderlich. Man erhält einen Vorverbund. Anschließend wird auch die zweite Klebeoberfläche von der Schutzlinerschicht befreit und auf das zweite Zielsubstrat gebracht. Auch dies kann durch Kaschierung mittels (Gummi-)walzen oder auch in Pressen erfolgen. Die Auswahl des Laminierprozesses richtet sich dabei nach der Beschaffenheit des Vorverbunds (starr oder flexibel) und des zweiten Zielsubstrats (starr oder flexibel). Dabei kann auch hier mit erhöhter Temperatur gearbeitet werden. Auch hier ist ein besonders hoher Druck beim Laminieren durch etwaige Haftklebrigkeit nicht in jedem Fall erforderlich. Um den Verbund zur Aushärtung zu bringen, muss zu einem Zeitpunkt, bevorzugt während und/oder nach dem im oben angegebenen Ablauf zweiten Laminierschritt, Wärme und/oder Strahlung eingebracht werden. Dies kann durch Nutzung einer Heizpresse, die bei der Lamination genutzt wird, erfolgen oder durch einen Wärmekanal, der zum Beispiel mit einer IR-Strecke ausgestattet ist, bzw. eine Strahlungsquelle (insbesondere für UV). Besonders geeignet sind auch Wärmekammern und Autoklaven. Letztere insbesondere, wenn der Verbund noch mit Druck beaufschlagt werden soll, um die Laminatqualität final zu optimieren. Bei der Wärmezuführung ist darauf zu achten, dass die Temperatur ausreicht, um den latentreaktiven thermisch aktivierbaren Initiator zu aktivieren, dass aber empfindliche Bauteilelemente nicht thermisch geschädigt werden.

Im Folgenden wird die Erfindung durch Beispiele näher erläutert, ohne die Erfindung damit einschränken zu wollen.

## Beispiele

Testmethoden

*Test A - Volumenpermeabilität (OTR, WVTR)*

Die Bestimmung der Permeabilität für Sauerstoff (OTR) und Wasserdampf (WVTR) erfolgt nach DIN 53380 Teil 3 beziehungsweise ASTM F-1249. Die Klebemasse wird dazu mit einer anzugebenden Schichtdicke (zum Beispiel 50 μm) auf eine permeable Membran aufgebracht und anschließend für 30 min bei 120 °C gehärtet. Alternativ kann auch eine Folie untersucht werden. Die Sauerstoffdurchlässigkeit wird bei 23 °C und einer relativen Feuchte von 50 % gemessen mit einem Messgerät Mocon OX-Tran 2/21. Die Wasserdampfdurchlässigkeit wird bei 37,5 °C und einer relativen Feuchte von 90 % bestimmt.

*Test B - Lebensdauertest ("Lag-Time")*

Als ein Maß für die Bestimmung der Lebensdauer eines (opto)elektronischen Aufbaus wurde ein Calciumtest herangezogen. Dieser ist in der Figur 4 gezeigt. Dazu wird im Vakuum eine 10 x 10 $mm^2$ große, dünne Calciumschicht 23 auf eine Glasplatte 21 abgeschieden und danach unter Stickstoffatmosphäre gelagert. Die Dicke der Calciumschicht 23 liegt bei etwa 100 nm. Für die Verkapselung der Calciumschicht 23 wird ein Klebeband (23 x 23 $mm^2$) mit der zu testenden Klebemasse 22 sowie einer Dünnglasscheibe 24 (30 μm, Firma Schott) als Trägermaterial verwendet. Zur Stabilisierung war die Dünnglasscheibe mit einer 100 μm dicken PET-Folie 26 mittels eines 50 μm dicken Transferklebebands 25 aus einer optisch hochtransparenten Acrylathaftklebemasse laminiert. Die Klebemasse 22 wird bei 70 °C so auf der Glasplatte 21 appliziert, dass die Klebemasse 22 den Calciumspiegel 23 mit einem allseitig überstehenden Rand von 6,5 mm (A-A) abdeckt. Es wurde für 30 min bei 120 °C gehärtet. Aufgrund des undurchlässigen Glasträgers 24 wird nur die Permeation durch die Klebemasse oder entlang der Grenzflächen ermittelt.

Der Test basiert auf der Reaktion von Calcium mit Wasserdampf und Sauerstoff, wie sie beispielsweise von A.G. Erlat et. al. in "47th Annual Technical Conference Proceedings-Society of Vacuum Coaters", 2004, Seiten 654 bis 659, und von M. E. Gross et al. in "46th Annual Technical Conference Proceedings-Society of Vacuum Coaters", 2003, Seiten 89 bis 92, beschrieben sind. Dabei wird die Lichttransmission der Calciumschicht überwacht, welche durch die Umwandlung in Calciumhydroxid und Calciumoxid zunimmt. Diese erfolgt beim beschriebenen Prüfaufbau vom Rand her, so dass sich die sichtbare Fläche des Calciumspiegels verringert. Es wird die Zeit bis zur Halbierung der Lichtabsorption des Calciumspiegels als Lebensdauer bezeichnet, die Zeit bis zum Einsetzen einer stetigen Abnahme der Absorption als Durchbruchzeit oder "lag-time". Durch die Methode werden dabei sowohl der Abbau der Fläche des Calciumspiegels vom Rand aus und durch punktuellen Abbau in der Fläche als auch die homogene Verringerung der Schichtdicke des Calciumspiegels durch vollflächigen Abbau erfasst.

Als Messbedingungen wurden 85 °C und 85 % relative Luftfeuchte gewählt. Die Muster wurden mit einer Schichtdicke der Haftklebemasse von 50 μm vollflächig und blasenfrei verklebt. Die Messungen wurden an vernetzten

Klebebändern vorgenommen. Der Messwert (in h) ergab sich als Mittelwert aus drei Einzelmessungen.

*Test C - Molmasse (GPC)*

Die Bestimmung von Molmassen erfolgt an 100 µL klarfiltrierter Probe (Probenkonzentration 1,5 g/L). Als Eluent wird Tetrahydrofuran mit 0,1 Vol.-% Trifluoressigsäure eingesetzt, als interner Standard 200 ppm (m/V) Toluol. Die Messung erfolgt bei 25°C.

Als Vorsäule wird eine Säule Typ PSS - SDV, 10 µm, ID 8.0 mm x 50 mm (Angaben hier und im Folgenden in der Reihenfolge: Typ, Partikelgrößе, Innendurchmesser x Länge) verwendet. Zur Auftrennung wird eine Säule des Typs PSS - SDV, 10 µm linear one, ID 8.0 mm x 300 mm eingesetzt (Säulen und Detektor der Firma Polymer Standards Service; Detektion mittels Detektor PSS-SECcurity 1260 RID). Die Durchflussmenge beträgt 0,5 mL pro Minute. Die Kalibration wird mit Polystyrol-Standards im Trennbereich der Säule durchgeführt und unter Nutzung der bekannten Mark Houwink Koeffizienten a und K universell in eine Polymethylmethacrylat-Kalibrierung umgerechnet.

*Test D - Glasübergangstemperatur,_Aktivierungstemperatur (DSC)*

D1: Die Bestimmung der Glasübergangstemperatur ($T_G$) erfolgt mittels dynamischer Differenzkalorimetrie (DSC; englisch Differential Scanning Calorimetry) an einem DSC 204 F1 der Firma Netzsch. Die Probe wird in verstärkte Aluminium-Tiegel (Deckel manuell gelocht) eingewogen. Das Temperaturprogramm fährt zwei Aufheizrampen, zuerst wird von 25 °C auf -100 °C mit flüssigem Stickstoff heruntergekühlt und mit 10 K/min auf 180 °C aufgeheizt. Glasübergänge werden als Stufen im Thermogramm erkannt. Die Glasübergangstemperatur wird folgendermaßen ausgewertet (siehe dazu Figur 5). An die Basislinie des Thermogramms vor 1 und nach 2 der Stufe wird jeweils eine Tangente angelegt. Im Bereich der Stufe wird eine Ausgleichsgerade 3 parallel zur Ordinate so gelegt, dass sie die beiden Tangenten schneidet und zwar so, dass zwei Flächen 4 und 5 (zwischen der jeweils einen Tangente, der Ausgleichsgeraden und der Messkurve) gleichen Inhalts entstehen. Der Schnittpunkt der so positionierten Ausgleichsgeraden mit der Messkurve gibt die Glasübergangstemperatur. Anschließend wird wieder auf -100 °C heruntergekühlt und mit 10 K/min auf 250 °C aufgeheizt. Es werden die erste und die zweite Aufheizrampe ausgewertet. Die so ermittelte Glasübergangstemperatur der ersten Aufheizkurve entspricht der Glasübergangstemperatur des unvernetzten Polymers. Die ermittelte Glasübergangstemperatur resultierend aus der zweiten Aufheizkurve entspricht einer, durch die thermische Beanspruchung der Messung vernetzten Glasübergangstemperatur des Polymers bzw. einer durch die Aktivierung eines thermischen Vernetzer / Initiators vernetzten Polymers bzw. Formulierung, im Falle der Anwesenheit eines solchen in einem Polymer bzw. einer Formulierung. Dieser Messzyklus kann auch zur Untersuchung der Glasübergangstemperatur gehärteter Klebemasse-/bandmuster genutzt werden oder für nicht reaktive Materialien.

D2: Die für die thermische Härtung der kationisch härtbaren Reaktivharze erforderliche Aktivierungstemperatur wird über Differential Scanning Calorimetry (DSC) bestimmt. Die Muster werden in Al-Tiegeln mit gelochtem Deckel und Stickstoffatmosphäre vermessen. Um ein gutes Bedecken des Tiegelbodens mit der Probe zu erreichen, wird das Muster im Gerät zunächst auf 40 °C aufgeheizt und wieder auf 25 °C abgekühlt. Die eigentliche Messung wird bei 25 °C gestartet, die Aufheizkurve läuft mit einer Heizrate von 10 K/min. Die erste Aufheizkurve wird ausgewertet. Das Anspringen der thermisch initiierten Härtungsreaktion wird von der Messapparatur durch die damit verbundene frei werdende Reaktionsenthalpie registriert und als exothermes Signal (Peak) im Thermogramm angezeigt. Als Aktivierungstemperatur wird diejenige Temperatur dieses Signals verwendet, bei der die Messkurve von der Basislinie abzuweichen beginnt (als ein Hilfsmittel, um diesen Punkt zu finden, kann die erste Ableitung des Thermogramms dienen; der Beginn der Reaktion kann mit dem Punkt im Thermogramm in Verbindung gebracht werden, bei dem die Differenz der ersten Ableitung des betreffenden Peaks im Onsetbereich und der ersten Ableitung der Basislinie einen Betrag von 0,01 mW/(K min) annimmt; sind exotherme Signal im Diagramm nach oben dargestellt, dann ist das Vorzeichen positiv, sind sie nach unten dargestellt, dann ist das Vorzeichen negativ). Es wird zudem das Integral, normiert auf die eingewogene Mustermenge, notiert.

*Test E - Farbwert $\Delta b^*$*

Es wird gemäß DIN 6174 vorgegangen und die Farbcharakteristik im dreidimensionalen Raum, aufgespannt durch die drei Farbparameter L*, a* und b*, nach CIELab untersucht. Dazu wird ein BYK Gardener spectro-guide Messgerät verwendet, ausgestattet mit einer D/65° Lampe. Innerhalb des CIELab-Systems gibt L* den Grauwert, a* die Farbachse von grün nach rot und b* die Farbachse von blau nach gelb an. Der positive Wertebereich für b* gibt die Intensität des gelben Farbanteil an. Als Referenz diente eine weiße Keramikfliese mit einem b* von 1,86. Diese Fliese dient zudem als Probenhalter, auf den die zu prüfende Klebschicht auflaminiert wird. Die Farbmessung erfolgt an der jeweiligen reinen Klebschicht in 50 µm Schichtdicke, nachdem diese von den Trennlinern befreit und auf der Kachel für 30 min bei 120 °C gehärtet worden ist. $\Delta b^*$ ist die Differenz aus der Farbwertbestimmung für das Klebefilmmuster

appliziert auf der Substratfliese und der Farbwertbestimmung der reinen Substratfliese.

*Test F - Transparenz*

Zur Probenvorbereitung wurde ein 30 μm ungehärtetes Transferklebeband blasenfrei auf eine Polycarbonat-Folie (125 μm Lexan 8010 mit frisch ausgedeckten Oberflächen; Haze dieser Folie allein 0,09 %) aufgebracht. Bei Bedarf erfolgt die Lamination bei erhöhter Temperatur aber unterhalb der Aktivierungstemperatur des Musters (im Fall von Beispiel E1 bei 70 °C). Die Muster wurden nach Methode F1 und F2 vermessen.

F1: Die Transmission der Klebemasse wurde über das VIS-Spektrum bestimmt. Die Aufnahmen des VIS-Spektrums wurden an einem UVIKON 923 der Firma Kontron durchgeführt. Der Wellenlängenbereich des gemessenen Spektrums umfasst alle Wellenlängen zwischen 800 nm und 400 nm bei einer Auflösung von 1 nm. Es wurde eine Leerkanalmessung als Referenz über den gesamten Wellenlängenbereich durchgeführt. Für die Angabe des Ergebnisses wurden die Transmissionsmessungen im angegebenen Bereich gemittelt. Eine Korrektur von Grenzflächenreflextionsverlusten wird nicht vorgenommen.

F2: Der Haze-Wert beschreibt den Anteil des transmittierten Lichts, der von der durchstrahlten Probe nach vorne großwinklig gestreut wird. Somit quantifiziert der Haze-Wert Materialfehler in der Oberfläche oder der Struktur, die die klare Durchsicht stören.

Das Verfahren zur Messung des Haze-Wertes wird in der Norm ASTM D 1003 beschrieben. Die Norm erfordert die Messung von vier Transmissionsmessungen. Für jede Transmissionsmessung wird der Lichttransmissionsgrad berechnet. Die vier Transmissionsgrade werden zum prozentualen Haze-Wert verrechnet. Der Haze-Wert wird mit einem Haze-gard Dual von Byk-Gardner GmbH gemessen.

*Test G - Brechungsindex*

Der Brechungsindex wird mit Hilfe eines Refraktometers Abbemat 350 (Fa. Anton Paar) bestimmt bei 20 °C unter Verwendung von Natrium-D-Licht (589 nm) bestimmt. Haftklebrige Klebemasseschichten werden direkt auf das Messfenster geklebt und die Messung gestartet. Für nicht haftklebrige Klebemasseschichten wird das flächige Muster auf das Messfenster gelegt und mittels eines hierfür vorgesehenen Stempels aufgedrückt und die Messung gestartet. Das Ergebnis ist der Mittelwert aus zwei Einzelmessungen.

Eingesetzte Rohstoffe

| | | |
|---|---|---|
| Vazo® 52 | 2,2-Azobis(2,4-dimethylvaleronitril) | Fa. DuPont |
| TTA15 | 3,4-Epoxycyclohexylmethylmethacrylat | Fa. Tetrachem |
| K-Pure® CXC 2678 | thermischer Aktivator auf Basis eines quarternären Ammonimumsalzes der Trifluoromethansulfonsäure | Fa. King Industries |
| Uvacure 1500 | (3',4'-Epoxycyclohexan)-methyl-(3,4-epoxycyclohexyl)-carboxylat | Fa. Allnex |
| Dynasylan® GLYEO | 3-Glycidyloxypropyltriethoxysilan | Fa. Evonik |
| Dynasylan ® MEMO | 3-Methacryloyloxypropyltrimethoxysilan | Fa. Evonik |

Beispiel A

Ein für radikalische Polymerisationen konventioneller, druckfester 2 L-Polymerisationsreaktor wurde mit 100 g 3,4-Epoxycyclohexylmethylmethacrylat und 396 g Methylethylketon gefüllt. Nach 45 Minuten Durchleiten von Stickstoffgas unter Rühren wurde der Reaktor auf 70 °C Produkttemperatur hochgeheizt und bis zum Sieden evakuiert. Anschließend wurden 2,0 g 2,2-Azobis(2,4-dimethylvaleronitril) gelöst in 4,0 g Methylethylketon hinzugegeben. Die Reaktion wird bei konstanten 70 °C Produkttemperatur unter Siedekühlung durchgeführt. Nach 1 h Reaktionszeit wurden auf 70 °C vortemperierte und für 45 Minuten mit Stickstoff durchleitete 100 g 3,4-Epoxycyclohexylmethylmethacrylat hinzugegeben und 2,0 g 2,2-Azobis(2,4-dimethylvaleronitril) gelöst in 4,0 g Methylethylketon hinzugegeben. Nach 2 h

Reaktionszeit wurden auf 70 °C vortemperierte und für 45 Minuten mit Stickstoff durchleitete 100 g 3,4-Epoxycyclohexylmethylmethacrylat hinzugegeben und 2,0 g 2,2-Azobis(2,4-dimethylvaleronitril) gelöst in 4,0 g Methylethylketon hinzugegeben. Nach 3 h Reaktionszeit wurden auf 70 °C vortemperierte und für 45 Minuten mit Stickstoff durchleitete 100 g 3,4-Epoxycyclohexylmethylmethacrylat hinzugegeben und 2,0 g 2,2-Azobis(2,4-dimethylvaleronitril) gelöst in 4,0 g Methylethylketon hinzugegeben. Die Reaktion wurde nach 24 h Reaktionszeit abgebrochen und auf Raumtemperatur abgekühlt.

Das resultierende Polymer wies eine gewichtsmittlere Molmasse nach Test C von 15 900 g/mol auf. Es enthielt zu 100 % Monomere der (Co)Monomersorte (a). Die Glasübergangstemperatur des ungehärteten Polymers betrug 32 °C, ermittelt aus der ersten Aufheizkurve nach Test D1. Das durch Selbsthärtung während der Heizphase im DSC-Experiment erzeugte (teil)gehärtete Material wies in der zweiten Heizkurve eine Glasübergangstemperatur von 72 °C auf.

Anhand dieser DSC-Ergebnisse ist im Vergleich zwischen erfindungsgemäßem härtbaren Ausgangspolymer und (teil)gehärtetem Polymer erkennbar, dass mit dem während der Härtungsreaktion ablaufenden Molmassenanstieg ein Anstieg der Glasübergangstemperatur verknüpft ist.

Beispiel E1

236,1 g der Polymerlösung aus Beispiel A (Feststoffgehalt 49,8 Gew.-%) wurden mit 78,4 g des niederviskosen Reaktivharzes (3,4-Epoxycyclohexan)-methyl-3,4-epoxycyclohexylcarboxylat (Uvacure 1500, Allnex) als Komponente (C3) und 4,0 g 3-Glycidyloxypropyltriethoxysilan als weiteres Additiv vermischt, so dass eine 63-Gew.-% Lösung resultierte.

Schließlich wurde der Lösung ein latentreaktiver thermisch aktivierbarer Initiator zugesetzt. Hierzu wurden 2,0 g (1 % bezogen auf die Gesamtformulierung) K Pure TAG 2678 (King Industries) als Initiator / Härter (B) abgewogen. Der Initiator wurde als 20 Gew.-%-ige Lösung in Aceton angesetzt und der oben genannten Lösung zugesetzt.

Mittels eines Rakelverfahrens wurde die Formulierung aus Lösung auf einen silikonisierten PET-Liner beschichtet und bei 50 °C für 120 min getrocknet. Der Masseauftrag lag anschließend bei 50 g/$m^2$. Das Muster wurde mit einer weiteren Lage eines silikonisierten aber leichter trennenden PET-Liners eingedeckt.

Die Aktivierungstemperatur dieser Muster nach Test D2 (DSC) lag bei 90 °C.Muster in Klebeverbünden wurden bei 120 °C für 30 min gehärtet.

Im Hinblick auf Barriereeigenschaften wurde eine WVTR-Messung (Test A) durchgeführt. Für das 50 g/$m^2$ dicke Transferklebeband im gehärteten Zustand lag der WVTR bei 192 g / $m^2$ d. Es wurde für dieses Muster zudem ein Lebensdauertest (Test B) durchgeführt. Die Durchbruchzeit ("Lag-Time") betrug > 250 h.

Die Untersuchung der optischen Eigenschaften der gehärteten Muster nach Ausdeckung beider PET-Liner ergab einen Brechungsindex (Test G) von 1,514. Die Transmission (Test F1) betrug 93 % (unkorrigiert) und der Haze (Test F2) 0,9 %. Der Gelbwert $\Delta$b lag bei +0,09 und nach Lagerung des Musters auf der Substratkachel für 1 Woche bei 23 °C und 50 % rel. Luftfeuchtigkeit immer noch bei +0,09.

Vergleichsbeispiel V1

Es wurde ein Copolymer (A) mit geringerem Anteil an (Co)Monomer (a) vergleichsweise in Bezug auf die Durchbruchzeit untersucht. Die Zusammensetzung betrug 5 % 3,4-Epoxycyclohexylmethylmethacrylat, 5 % 3-Methacryloyloxypropyltrimethoxysilan, 25 % n-Vinylcaprolactam, 32,5 % n-Butylacrylat und 32,5 % 2-Ethylhexylacrylat.

Die Lag-Time für das kationisch gehärtete Muster lag bei 0 h.

Das Beispiel E1 führt vor Augen, dass ein Reaktivklebeband auf Basis einer erfindungsgemäßen härtbaren Klebemasse nach Härtung ausgezeichnet zur Verkapselung feuchtigkeitsempfindlicher Strukturen geeignet ist. Für die Verkapselung empfindlicher (Opto-)elektronik ist überraschenderweise die Volumenpermeabilität nicht entscheidend. Diese liegt, was an sich für polare Klebemassen auf Poly(meth)acrylat-Basis zu erwarten war, auf einem nicht ultimativ niedrigen Niveau. Für die Verkapselung ist aber in erster Linie die Durchbruchzeit, d. h. die Lebensdauer des empfindlichen Aufbaus von Relevanz. Und diese anwendungsrelevante Anforderung wird von dem erfindungsgemäßen Klebesystem hervorragend bestanden. Für ein im Vergleich untersuchtes Klebemassesystem, das zwar ebenfalls ein epoxidfunktionalisiertes Poly(meth)acrylat ist (Vergleichsbeispiel V1) aber einen deutlich geringeren Anteil an Epoxid-Funktionalität enthält, zeigt sich, dass ein solches System dagegen für die Verkapselungsaufgabe nicht geeignet ist.

Über die Barriereeigenschaften hinaus weist das Klebeband aus Beispiel E1 zudem attraktive optische Eigenschaften auf, so dass Anwendungen in optischen Anzeigeeinheiten, wie Displays insbesondere OLEDs möglich sind.

**Patentansprüche**

1. Ein- oder doppelseitig klebendes Klebeband enthaltend härtbare Klebemasse zur Kapselung einer elektronischen

oder optoelektronischen Anordnung gegen Permeanten, aus den folgenden Komponenten:

(A) 20 bis 99,9 Gew.-% (bezogen auf die Gesamtheit der härtbaren Klebemasse) eines mit Epoxygruppen funktionalisierten (Co)Polymers mit einer gewichtsmittleren Molmasse im Bereich von mindestens 5 000 g/mol, bestimmt mittels GPC gemäß Messmethode C, auf Basis von mehr als 30 bis 100 Gew.-%, bevorzugt 50 bis 100 Gew.-%, (bezogen auf die Gesamtheit der dem epoxidfunktionalisierten (Co)Polymer zugrundeliegenden Monomere) zumindest einer Sorte eines mit einer Epoxy-Gruppe funktionalisierten (meth)acrylischen (Co)Monomers (a),
(B) 0,1 bis 5 Gew.-% (bezogen auf die Gesamtheit der härtbaren Klebemasse) zumindest eines Härters, der thermisch und/oder durch Zufuhr von UV-Strahlung die - insbesondere kationische - Härtung des (Co)Polymers (A) unter Reaktion seiner Epoxy-Gruppen induzieren kann,
(C) optional 0 bis 79,9 Gew.-% weiterer Bestandteile.

2. Klebeband nach Anspruch 1, **dadurch gekennzeichnet, dass**
die gewichtsmittlere Molmasse des epoxidfunktionalisierten (Co)Polymers mindestens 10 000 g/mol, bevorzugt mindestens 20 000 g/mol beträgt, jeweils bestimmt mittels GPC gemäß Messmethode C.

3. Klebeband nach einem der vorangehenden Ansprüche, **dadurch gekennzeichnet, dass**
die gewichtsmittlere Molmasse des epoxidfunktionalisierten (Co)Polymers höchstens 200 000 g/mol, bevorzugt höchstens 150 000 g/mol, sehr bevorzugt höchstens 100 000 g/mol beträgt, jeweils bestimmt mittels GPC gemäß Messmethode C.

4. Klebeband nach einem der vorangehenden Ansprüche, **gekennzeichnet durch** haftklebrige Eigenschaften der härtbaren Klebemasse unter Standardbedingungen von 23 °C und 50% relativer Luftfeuchtigkeit.

5. Klebeband nach einem der vorangehenden Ansprüche, **dadurch gekennzeichnet, dass**
für ein, mehrere oder alle der mit einer Epoxy-Gruppe funktionalisierten (meth)acrylischen (Co)Monomere (a) cycloaliphatische Epoxide eingesetzt werden.

6. Klebeband nach Anspruch 5, **dadurch gekennzeichnet, dass**
als cycloaliphatische Epoxide 3,4-Epoxycyclohexyl-substituierte Monomere gewählt werden, insbesondere gewählt aus der Gruppe: 3,4-Epoxycyclohexylmethylmethacrylat, 3,4-Epoxycyclohexylmethylacrylat, 3,4-Epoxycyclohexylmethacrylat, 3,4-Epoxycyclohexylacrylat.

7. Klebeband nach einem der vorangehenden Ansprüche, **dadurch gekennzeichnet, dass**
als Comonomere bei der Herstellung des funktionalisierten (Co)Polymers Siliziumhaltige Verbindungen, insbesondere acrylierte oder methacrylierte Alkoxysilan-haltige Comonomere, eingesetzt werden.

8. Klebeband nach einem der vorangehenden Ansprüche, **dadurch gekennzeichnet, dass**
die Klebemasse thermisch aktivierbare Härter für eine kationische Härtung von Epoxiden in Form thermisch aktivierbarer Säurebildner (Thermal Acid Generater, TAG) enthalten.

9. Klebeband nach Anspruch 8, **dadurch gekennzeichnet, dass**
als thermisch aktivierbarer Härter für eine kationische Härtung von Epoxiden ein oder mehrere Vertreter aus der folgenden Liste eingesetzt werden:
Pyridiniumsalze, Ammoniumsalze - wie insbesondere Aniliniumsalze -, Sulfoniumsalze - wie insbesondere Thiolaniumsalze -, Lanthanoidtriflate.

10. Klebeband nach zumindest einem der vorhergehenden Ansprüche,
**dadurch gekennzeichnet, dass**
die Klebemasse Photoinitiatoren (Photo Acid Generator, PAG) als Härter enthält.

11. Klebeband nach Anspruch 10,
**dadurch gekennzeichnet, dass**
solche Photoinitiatoren gewählt sind, die oberhalb 250 nm und unterhalb 350 nm UV-Licht absorbieren.

12. Klebeband nach zumindest einem der vorhergehenden Ansprüche,
**dadurch gekennzeichnet, dass**

die Klebemasse zumindest ein Klebharz enthält.

**13.** Klebeband nach zumindest einem der vorhergehenden Ansprüche,
**dadurch gekennzeichnet, dass**
die Klebemasse zumindest ein Reaktivharz enthält, das aliphatischer oder cycloaliphatischer Natur ist.

**14.** Klebeband nach zumindest einem der vorhergehenden Ansprüche,
**dadurch gekennzeichnet, dass**
die Klebemasse ein oder mehrere Additive enthält,
vorzugsweise ausgewählt aus der Gruppe bestehend aus Plastifizierungsmitteln, primären Antioxidantien, sekundären Antioxidantien, Prozessstabilisatoren, Lichtschutzmitteln, Verarbeitungshilfsmittel, Polymeren, insbesondere elastomerer oder thermoplastisch elastomerer Natur.

**15.** Klebeband nach einem der vorangehenden Ansprüche, **dadurch gekennzeichnet, dass**
ein oder mehrere Silane beigemischt sind, wobei die Silane ausgewählt sind aus Methyltrimethoxysilan, Methyltriethoxysilan, Dimethyldimethoxysilan, Dimethyldiethoxysilan, Trimethylethoxysilan, Ethyltrimethoxysilan, Propyltrimethoxysilan, Propyltriethoxysilan, iso-Butyltrimethoxysilan, iso-Butyltriethoxysilan, Octyltrimethoxysilan, Octyltriethoxysilan, iso-Octyltrimethoxysilan, iso-Octyltriethoxysilan, Hexadecyltrimethoxysilan, Hexadecyltriethoxysilan, Octadecylmethyldimethoxysilan, Phenyltrimethoxysilan, Phenyltriethoxysilan, Cyclohexylmethyldimethoxysilan, Dicyclopentyldimethoxysilan, mit einer Trimethoxysilan-Gruppe verknüpftem Polyethylenglykol, Vinyltrimethoxysilan, Vinyltriethoxysilan, Vinyl-tri(2-methoxyethoxy)-silan, Vinyltriisopropoxysilan, Vinyldimethoxymethylsilan, Vinyltriacetoxysilan, 3-Glycidyloxypropyltrimethoxysilan, 3-Glycidyloxypropyltriethoxysilan, 2-(3,4-Epoxycyclohexyl)-ethyltriethoxysilan, 3-Glycidyloxypropyldiethoxymethylsilan, 3-Methacryloyloxypropyltrimethoxysilan, 3-Methacryloyloxypropyltriethoxysilan, 3-Methacryloyloxypropyltriisopropoxysilan, 3-Methacryloyloxypropyldimethoxymethylsilan, 3-Methacryloyloxypropyldiethoxymethylsilan, 3-Chloropropyltrimethoxysilan, 3-Chloropropyltriethoxysilan, 3-Ureidopropyltrimethoxysilan, 3-Ureidopropyltriethoxysilan, 2-Hydroxy-4-(3-triethoxysilylpropoxy)-benzophenon und 4-(3'-Chlorodimethylsilylpropoxy)-benzophenon.

**16.** Klebeband nach zumindest einem der vorhergehenden Ansprüche,
**dadurch gekennzeichnet, dass**
die Klebemasse einen oder mehrere Füllstoffe enthält,
vorzugsweise nanoskalige Füllstoffe, transparente Füllstoffe und/oder Getter-und/oder Scavenger-Füllstoffe.

**17.** Klebeband nach zumindest einem der vorhergehenden Ansprüche,
**dadurch gekennzeichnet, dass**
die Klebemasse im sichtbaren Licht des Spektrums (Wellenlängenbereich von etwa 400 nm bis 800 nm) transparent ist und/oder eine Transmission (nach Test F1) von mindestens 75 %, insbesondere mindestens 90 % aufweist.

**18.** Klebeband nach zumindest einem der vorhergehenden Ansprüche,
**dadurch gekennzeichnet, dass**
die Klebemasse einen Haze (nach Test F2) von höchstens 5,0 %, bevorzugt von höchstens 2,5 % zeigt.

**19.** Klebeband nach einem der vorangehenden Ansprüche, **dadurch gekennzeichnet, dass**
die Klebemasse eine Durchbruchzeit nach Test B von mindestens 150 h, bevorzugt von mindestens 250 h aufweisen.

**20.** Klebeband nach einem der vorangehenden Ansprüche enthaltend zumindest eine Schicht einer Klebemasse wie in zumindest einem der vorangehenden Ansprüche definiert und einen Träger,
**dadurch gekennzeichnet, dass**
der Träger eine Permeationsbarriere von WVTR < 0,1 g/($m^2$ d) und OTR < 0,1 $cm^3$/($m^2$ d bar) aufweist.

**21.** Klebeband nach Anspruch 20,
**dadurch gekennzeichnet, dass**
der Träger eine beschichtete Kunststofffolie ist.

**22.** Klebeband nach Anspruch 18,
**dadurch gekennzeichnet, dass**
der Träger eine Schicht eines flexiblen Dünnglases mit einer Schichtdicke von höchstens 1 mm, bevorzugt höchstens 100 μm aufweist, vorzugsweise der Träger aus einer Schicht eines Dünnglases mit einer Schichtdicke von höchstens

1 mm besteht, wobei weiter vorzugsweise das Dünnglas ein Borosilikatglas oder ein alkalifreies Aluminoborosilikatglas ist.

**23.** Klebeband nach Anspruch 22,
**dadurch gekennzeichnet, dass**
das Dünnglas in bandförmiger Geometrie vorliegt.

**24.** Verwendung eines ein- oder doppelseitig klebenden Klebebands nach zumindest einem der vorhergehenden Ansprüche zur Kapselung einer (opto-)elektronischen Anordnung.

**25.** Verwendung nach Anspruch 24,
**dadurch gekennzeichnet, dass**
die Klebemasse und/oder die zu kapselnden Bereiche der (opto)elektronischen Anordnung vor, während und/oder nach der Applikation der Klebemasse erwärmt werden.

**26.** Verwendung nach Anspruch 24 oder 25,
**dadurch gekennzeichnet, dass**
die Klebemasse nach der Applikation auf der (opto)elektronischen Anordnung teil- oder endvernetzt wird.

**27.** Elektronische Anordnung mit einer elektronischen Struktur, insbesondere einer organischen elektronischen Struktur, und einem ein- oder doppelseitig klebenden Klebeband enthaltend eine Klebmasse,
wobei die (opto)elektronische Struktur zumindest teilweise durch die Klebmasse gekapselt ist,
**dadurch gekennzeichnet,**
**dass** die Klebmasse wie in einem der vorherigen Ansprüche definiert ausgebildet ist und gehärtet vorliegt.

## Claims

**1.** Single- or double-sided adhesive tape comprising curable adhesive composition for encapsulation of an electronic or optoelectronic arrangement against permeants, composed of the following components:

(A) 20% to 99.9% by weight (based on the entirety of the curable adhesive composition) of a (co)polymer functionalized with epoxy groups and having a weight-average molar mass in the region of at least 5000 g/mol, determined by GPC by test method C, based on more than 30% to 100% by weight, preferably 50% to 100% by weight, (based on the entirety of the parent monomers of the epoxy-functionalized (co)polymer) of at least one type of (meth)acrylic (co)monomer (a) functionalized with an epoxy group,
(B) 0.1% to 5% by weight (based on the entirety of the curable adhesive composition) of at least one curing agent that can induce the curing - especially cationic curing - of the (co)polymer (A) with reaction of its epoxy groups by thermal means and/or by supply of UV radiation,
(C) optionally 0% to 79.9% by weight of further constituents.

**2.** Adhesive tape according to Claim 1, **characterized in that**
the weight-average molar mass of the epoxy-functionalized (co)polymer is at least 10 000 g/mol, preferably at least 20 000 g/mol, in each case determined by GPC by test method C.

**3.** Adhesive tape according to either of the preceding claims, **characterized in that**
the weight-average molar mass of the epoxy-functionalized (co)polymer is at most 200 000 g/mol, preferably at most 150 000 g/mol, very preferably at most 100 000 g/mol, in each case determined by GPC by test method C.

**4.** Adhesive tape according to any of the preceding claims, **characterized by**
pressure-sensitive adhesive properties of the curable adhesive composition under standard conditions of 23°C and 50% relative air humidity.

**5.** Adhesive tape according to any of the preceding claims, **characterized in that**
cycloaliphatic epoxides are used for one, more than one or all the (meth)acrylic (co)monomers (a) functionalized with an epoxy group.

**6.** Adhesive tape according to Claim 5, **characterized in that**

cycloaliphatic epoxides chosen are 3,4-epoxycyclohexyl-substituted monomers, especially chosen from the group of: 3,4-epoxycyclohexylmethyl methacrylate, 3,4-epoxycyclohexylmethyl acrylate, 3,4-epoxycyclohexyl methacrylate, 3,4-epoxycyclohexyl acrylate.

**7.** Adhesive tape according to any of the preceding claims, **characterized in that** comonomers used in the preparation of the functionalized (co)polymer are silicon compounds, especially acrylated or methacrylated alkoxysilane-containing comonomers.

**8.** Adhesive tape according to any of the preceding claims, **characterized in that** the adhesive composition comprises thermally activatable curing agents for cationic curing of epoxides in the form of thermally activatable acid formers (thermal acid generators, TAGs).

**9.** Adhesive tape according to Claim 8, **characterized in that** the thermally activatable curing agents used for cationic curing of epoxides are one or more representatives from the following list:
pyridinium salts, ammonium salts - such as anilinium salts in particular, sulfonium salts - such as thiolanium salts in particular, lanthanoid triflates.

**10.** Adhesive tape according to at least one of the preceding claims,
**characterized in that**
the adhesive composition comprises photoinitiators (photo acid generators, PAGs) as curing agent.

**11.** Adhesive tape according to Claim 10,
**characterized in that**
photoinitiators chosen are those that absorb UV light above 250 nm and below 350 nm.

**12.** Adhesive tape according to at least one of the preceding claims,
**characterized in that**
the adhesive composition comprises at least one adhesive resin.

**13.** Adhesive tape according to at least one of the preceding claims,
**characterized in that**
the adhesive composition comprises at least one reactive resin that is aliphatic or cycloaliphatic in nature.

**14.** Adhesive tape according to at least one of the preceding claims,
**characterized in that**
the adhesive composition comprises one or more additives,
preferably selected from the group consisting of plastifying agents, primary antioxidants, secondary antioxidants, process stabilizers, light stabilizers, processing auxiliaries, polymers, especially those that are elastomeric or thermoplastic elastomeric in nature.

**15.** Adhesive tape according to any of the preceding claims, **characterized in that** one or more silanes have been mixed in, wherein the silanes are selected from methyltrimethoxysilane, methyltriethoxysilane, dimethyldimethoxysilane, dimethyldiethoxysilane, trimethylethoxysilane, ethyltrimethoxysilane, propyltrimethoxysilane, propyltriethoxysilane, isobutyltrimethoxysilane, isobutyltriethoxysilane, octyltrimethoxysilane, octyltriethoxysilane, isooctyltrimethoxysilane, isooctyltriethoxysilane, hexadecyltrimethoxysilane, hexadecyltriethoxysilane, octadecylmethyldimethoxysilane, phenyltrimethoxysilane, phenyltriethoxysilane, cyclohexylmethyldimethoxysilane, dicyclopentyldimethoxysilane, polyethylene glycol joined to a trimethoxysilane group, vinyltrimethoxysilane, vinyltriethoxysilane, vinyltri(2-methoxyethoxy)silane, vinyltriisopropoxysilane, vinyldimethoxymethylsilane, vinyltriacetoxysilane, 3-glycidyloxypropyl-trimethoxysilane, 3-glycidyloxypropyltriethoxysilane, 2-(3,4-epoxycyclohexyl)ethyltriethoxysilane, 3-glycidyloxypropyldiethoxymethylsilane, 3-methacryloyloxypropyltrimethoxysilane, 3-methacryloyl-oxypropyltriethoxysilane, 3-methacryloyloxypropyl-triisopropoxysilane, 3-methacryloyloxypropyl-dimethoxymethylsilane, 3-methacryloyloxypropyl-diethoxymethylsilane, 3-chloropropyltrimethoxysilane, 3-chloropropyltriethoxysilane, 3-ureidopropyltrimethoxysilane, 3-ureidopropyltriethoxysilane, 2-hydroxy-4-(3-triethoxysilylpropoxy)-benzophenone and 4-(3'-chlorodimethylsilylpropoxy)-benzophenone.

**16.** Adhesive tape according to at least one of the preceding claims,
**characterized in that**

the adhesive composition comprises one or more fillers,
preferably nanoscale fillers, transparent fillers and/or getter and/or scavenger fillers.

**17.** Adhesive tape according to at least one of the preceding claims,
**characterized in that**
the adhesive composition is transparent in the visible light of the spectrum (wavelength range from about 400 nm to 800 nm) and/or has a transmission (by test F1) of at least 75%, especially at least 90%.

**18.** Adhesive tape according to at least one of the preceding claims,
**characterized in that**
the adhesive composition shows a haze (by test F2) of not more than 5.0%, preferably of not more than 2.5%.

**19.** Adhesive tape according to any of the preceding claims, **characterized in that**
the adhesive composition has a penetration time by test B of at least 150 h, preferably of at least 250 h.

**20.** Adhesive tape according to any of the preceding claims comprising at least one layer of an adhesive composition according to at least one of the preceding claims and a carrier,
**characterized in that**
the carrier has a permeation barrier of WVTR < 0.1 g/($m^2$d) and OTR < 0.1 $cm^3$/($m^2$d bar).

**21.** Adhesive tape according to Claim 20,
**characterized in that**
the carrier is a coated polymer film.

**22.** Adhesive tape according to Claim 18,
**characterized in that**
the carrier has a layer of a flexible thin glass having a layer thickness of not more than 1 mm, preferably not more than 100 μm, the carrier preferably consisting of a layer of a thin glass having a layer thickness of not more than 1 mm, the thin glass further preferably being a borosilicate glass or an alkali-free aluminoborosilicate glass.

**23.** Adhesive tape according to Claim 22,
**characterized in that**
the thin glass is in strip geometry.

**24.** Use of a single- or double-sidedly adhesive tape according to at least one of the preceding claims for encapsulation of an (opto)electronic arrangement.

**25.** Use according to Claim 24,
**characterized in that**
the adhesive composition and/or the regions of the (opto)electronic arrangement to be encapsulated are heated before, during and/or after the application of the adhesive composition.

**26.** Use according to Claim 24 or 25,
**characterized in that**
the adhesive composition is partly or finally crosslinked after application to the (opto)electronic arrangement.

**27.** Electronic arrangement having an electronic structure, especially an organic electronic structure, and a single- or double-sidedly adhesive tape comprising an adhesive composition,
where the (opto) electronic structure has been at least partly encapsulated by the adhesive composition,
**characterized in that**
the adhesive composition is formed according to at least one of the preceding claims and is in cured form.

**Revendications**

**1.** Masse adhésive durcissable contenant un ruban adhésif simple face ou double face, pour encapsuler un arrangement électronique ou optoélectronique en le protégeant contre les perméants, ayant les constituants suivants :

(A) 20 à 99,9 % en poids (par rapport à la totalité de la masse adhésive durcissable) d'un (co)polymère fonctionnalisé par des groupes époxy, ayant une masse moléculaire moyenne en masse dans la plage d'au moins 5000 g/mol, déterminée par CPG par la méthode de mesure C, à base de plus de 30 à 100 % en poids, de préférence de 50 à 100 % en poids (par rapport à la totalité des monomères qui sont à la base du (co)polymère à fonctionnalité époxy) d'au moins un type d'un (co)monomère (méth)acrylique (a) fonctionnalisé par un groupe époxy,
(B) 0,1 à 5 % en poids (par rapport à la totalité de la masse adhésive durcissable) d'au moins un durcisseur, qui par voie thermique et/ou par apport d'un rayonnement UV peut induire le durcissement - en particulier cationique - du (co)polymère (A) grâce à une réaction de ses groupes époxy,
(C) éventuellement, 0 à 79,9 % en poids d'autres constituants.

2. Ruban adhésif selon la revendication 1, **caractérisé en ce que** la masse moléculaire moyenne en masse du (co)polymère à fonctionnalité époxyde est d'au moins 10 000 g/mol, de préférence d'au moins 20 000 g/mol, dans chaque cas déterminée par CPG par la méthode d'essai C.

3. Ruban adhésif selon l'une des revendications précédentes, **caractérisé en ce que** la masse moléculaire moyenne en masse du (co)polymère à fonctionnalité époxyde est d'au plus 200 000 g/mol, de préférence d'au plus 150 000 g/mol, tout spécialement d'au plus 100 000 g/mol, dans chaque cas déterminée par CPG par la méthode d'essai C.

4. Ruban adhésif selon l'une des revendications précédentes, **caractérisé par** des propriétés autoadhésive de la masse adhésive durcissable dans des conditions standard de 23 °C et de 50 % d'humidité relative de l'air.

5. Ruban adhésif selon l'une des revendications précédentes, **caractérisé en ce que**, pour un, plusieurs ou la totalité des (co)monomères (méth)acryliques (a) fonctionnalisés par un groupe époxy, on utilise des époxydes cycloaliphatiques.

6. Ruban adhésif selon la revendication 5, **caractérisé en ce qu'**on choisit en tant qu'époxydes cycloaliphatiques des monomères à substitution 3,4-époxycyclohexyle, du groupe consistant en le méthylméthacrylate de 3,4-époxycyclohexyle, le méthylacrylate de 3,4-époxycyclohexyle, le méthacrylate de 3,4-époxycyclohexyle, l'acrylate de 3,4-époxycyclohexyle.

7. Ruban adhésif selon l'une des revendications précédentes, **caractérisé en ce qu'**on utilise en tant que monomères lors de la fabrication du (co)polymère fonctionnalisé des composés contenant du silicium, en particulier des comonomères contenant un alcoxysilane, acrylés ou méthacrylés.

8. Ruban adhésif selon l'une des revendications précédentes, **caractérisé en ce que** la masse adhésive contient des durcisseurs thermoactivables pour un durcissement cationique d'époxydes sous forme d'un générateur d'acide thermoactivable (Thermal Acid Generator, TAG).

9. Ruban adhésif selon la revendication 8, **caractérisé en ce qu'**on utilise en tant que durcisseur thermoactivable pour un durcissement cationique d'époxydes un ou plusieurs représentants de la liste suivante :
sels de pyridinium, sels d'ammonium - tels qu'en particulier les sels d'anilinium -, sels de sulfonium - tels qu'en particulier les sels de thiolanium -, triflates de lanthanides.

10. Ruban adhésif selon l'une des revendications précédentes, **caractérisé en ce que** la masse adhésive contient des photoamorceurs (Photo Acid Generator, PAG) en tant que durcisseurs.

11. Ruban adhésif selon la revendication 10, **caractérisé en ce qu'**on choisit les photoamorceurs qui absorbent la lumière UV au-delà de 250 nm et en-dessous de 350 nm.

12. Ruban adhésif selon au moins l'une des revendications précédentes, **caractérisé en ce que** la masse adhésive contient au moins une résine adhésive.

13. Ruban adhésif selon au moins l'une des revendications précédentes, **caractérisé en ce que** la masse adhésive contient au moins une résine réactive, qui est de nature aliphatique ou cycloaliphatique.

14. Ruban adhésif selon au moins l'une des revendications précédentes, **caractérisé en ce que** la masse adhésive contient un ou plusieurs additifs, choisis de préférence dans le groupe consistant en les plastifiants, les antioxydants

primaires, les antioxydants secondaires, les agents de stabilisation du procédé, les agents de protection contre la lumière, les auxiliaires de mise en œuvre, les polymères, en particulier de nature élastomère ou élastomère thermoplastique.

**15.** Ruban adhésif selon l'une des revendications précédentes, **caractérisé en ce qu'**on ajoute un ou plusieurs silanes, les silanes étant choisis parmi le méthyltriméthoxysilane, le méthyltriétoxysilane, le diméthyldiméthoxysilane, le diméthyldiéthoxysilane, le triméthyléthoxysilane, l'éthyltriméthoxysilane, le propyltriméthoxysylane, le propyltriéthoxysilane, l'isobutyltriméthoxysilane, l'isobutyltriéthoxysilane, l'octyltriméthoxysilane, l'octyltriéthoxysilane, l'isooctyltriméthoxysilane, l'isooctyltriéthoxysilane, l'hexadécyltriméthoxysilane, l'hexadécyltriéthoxysilane, l'octadécylméthyldiméthoxysilane, le phényltriméthoxysilane, le phényltriéthoxysilane, le cyclohexylméthyldiméthoxysilane, le dicyclopentyldiméthoxysilane, le polyéthylèneglycol lié à un groupe triméthoxysilane, le vinyltriméthoxysilane, le vinyltriéthoxysilane, le vinyl-tri(2-méthoxyéthoxy)-silane, le vinyltriisopropoxysilane, le vinyldiméthoxyméthylsilane, le vinyltriacéétoxysilane, le 3-glycidyloxypropyltriméthoxysilane, le 3-glycidyloxypropyltriéthoxysilane, le 2-(3,4-époxycyclohexyl)-éthyltriéthoxysilane, le 3-glycidyloxypropyldiéthoxyméthylsilane, le 3-méthacryloyloxypropyltriméthoxysilane, le 3-méthacryloyloxypropyltriéthoxysilane, 3-méthacryloyloxypropyltriisopropoxysilane, le 3-méthacryloyloxypropyldiméthoxyméthylsilane, le 3-méthacryloyloxypropyldiéthoxyméthylsilane, le 3-chloropropyltriméthoxysilane, le 3-chloropropyltriéthoxysilane, le 3-uréidopropyltriméthoxysilane, le 3-uréidopropyltriéthoxysilane, la 2-hydroxy-4-(3-triéthoxysilylpropoxy)-benzophénone et la 4-(3'-chlorodiméthylsilylpropoxy)-benzophénone.

**16.** Ruban adhésif selon au moins l'une des revendications précédentes, **caractérisé en ce que** la masse adhésive contient une ou plusieurs charges, de préférence des charges nanométriques, des charges transparentes et/ou des charges fixatrices et/ou pièges.

**17.** Ruban adhésif selon au moins l'une des revendications précédentes, **caractérisé en ce que** la masse adhésive est transparente à la lumière visible du spectre (plage de longueurs d'onde d'environ 400 nm à 800 nm) et/ou présente un facteur de transmission (selon l'essai F1) d'au moins 75 %, en particulier d'au moins 90 %.

**18.** Ruban adhésif selon au moins l'une des revendications précédentes, **caractérisé en ce que** la masse adhésive présente un voile (selon l'essai F2) d'au plus 5,0 %, de préférence d'au plus 2,5 %.

**19.** Ruban adhésif selon l'une des revendications précédentes, **caractérisé en ce que** la masse adhésive présente un temps de passage selon l'essai B d'au moins 150 h, de préférence d'au moins 250 h.

**20.** Ruban adhésif selon l'une des revendications précédentes, contenant au moins une couche d'une masse adhésive telle que définie dans au moins l'une des revendications précédentes et un support, **caractérisé en ce que** le support présente une barrière à la perméation ayant une WVTR <0,1 g/($m^2$d) et une OTR <0,1 $cm^3$/($m^2$d bar).

**21.** Ruban adhésif selon la revendication 20, **caractérisé en ce que** le support est une feuille plastique enduite.

**22.** Ruban adhésif selon la revendication 18, **caractérisé en ce que** le support comprend une couche d'un verre mince flexible ayant une épaisseur de couche d'au plus 1 mm, de préférence d'au plus 100 $\mu$m, de préférence le support étant constitué d'une couche d'un verre mince ayant une épaisseur de couche d'au plus 1 mm, le verre mince étant en outre, de préférence, un verre au borosilicate ou un verre à l'aluminoborosilicate sans alcali.

**23.** Ruban adhésif selon la revendication 22, **caractérisé en ce que** le verre mince se présente sous une géométrie de type bande.

**24.** Utilisation d'un ruban adhésif simple face ou double face selon au moins l'une des revendications précédentes, pour encapsuler un arrangement (opto)électronique.

**25.** Utilisation selon la revendication 24, **caractérisée en ce que** la masse adhésive et/ou les zones à encapsuler de l'arrangement (opto)électronique sont chauffées avant, pendant et/ou après application de la masse adhésive.

**26.** Utilisation selon la revendication 24 ou 25, **caractérisée en ce que** la masse adhésive est soumise à une réticulation partielle ou complète après application sur l'arrangement (opto)électronique.

**27.** Arrangement électronique ayant une structure électronique, en particulier une structure électronique organique, et un ruban adhésif simple face ou double face contenant une masse adhésive, la structure (opto)électronique étant

au moins partiellement encapsulée par la masse adhésive, **caractérisé en ce que** la masse adhésive a la constitution telle que définie dans l'une des revendications précédentes et se présente sous forme durcie.

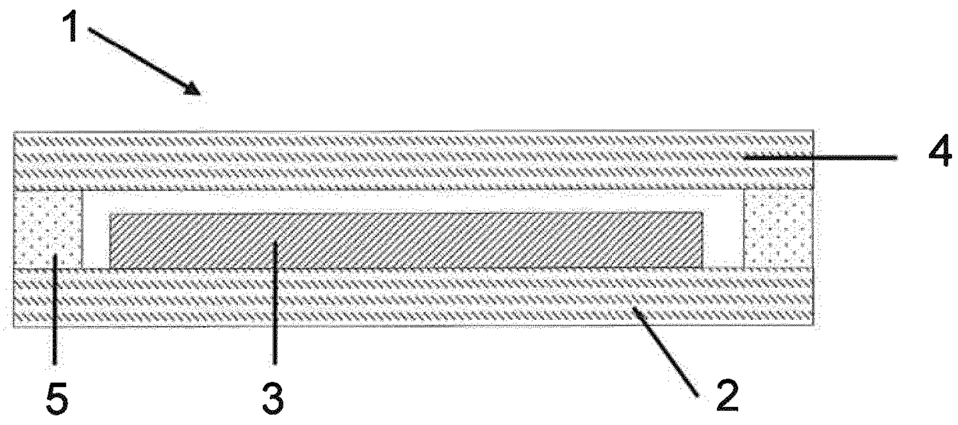


Fig. 1

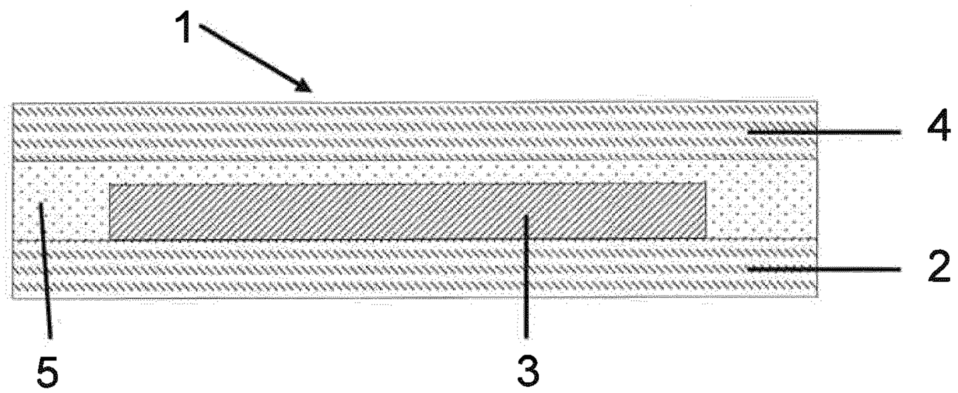


Fig. 2

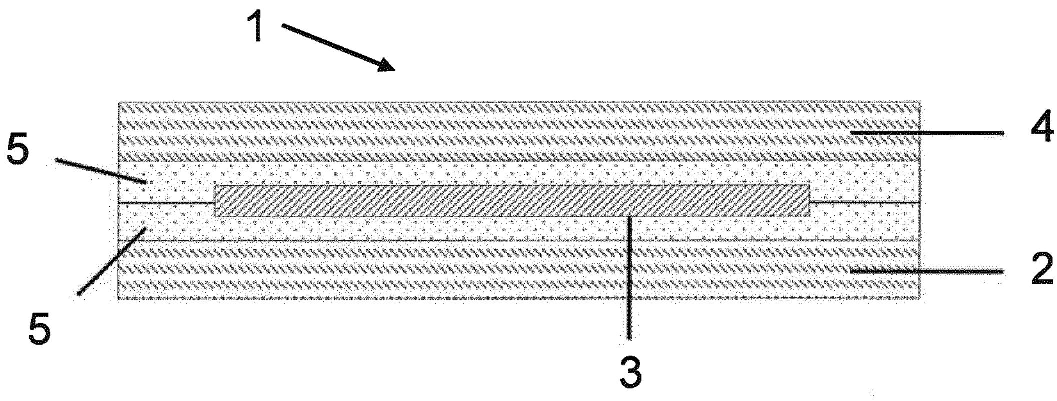


Fig. 3

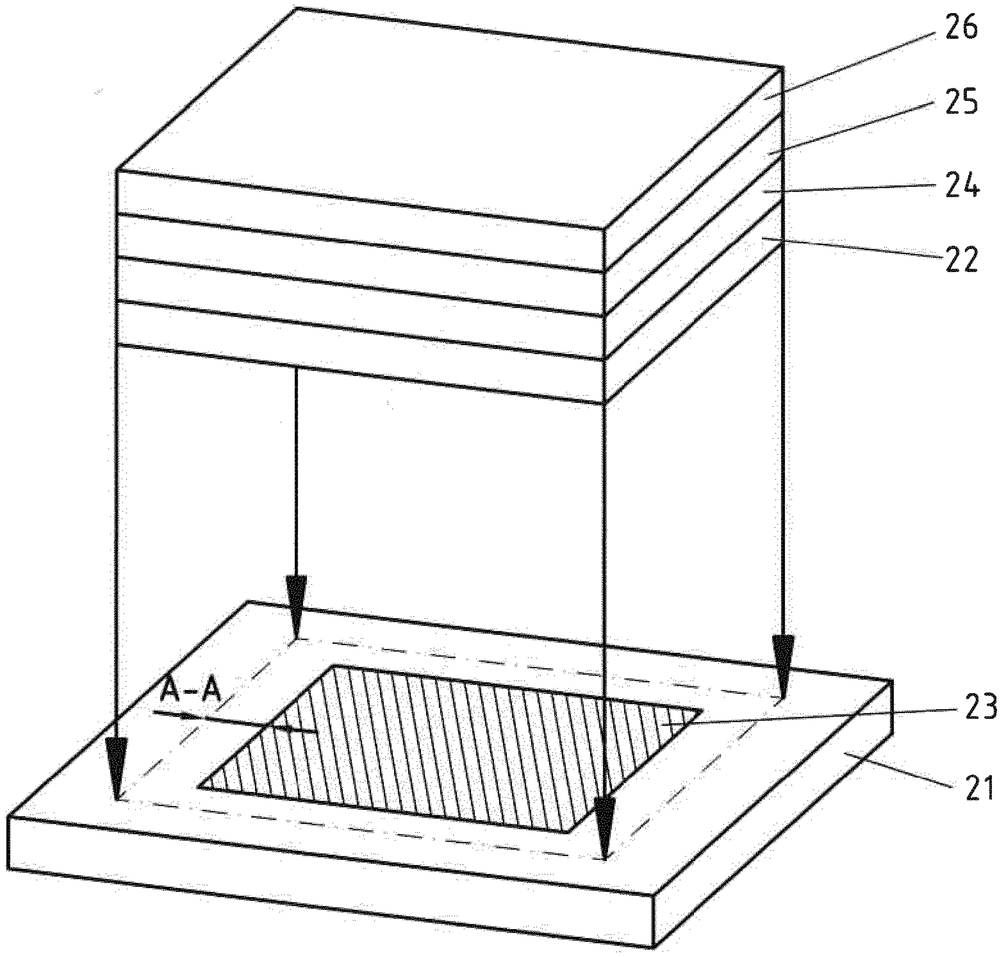


FIG.4

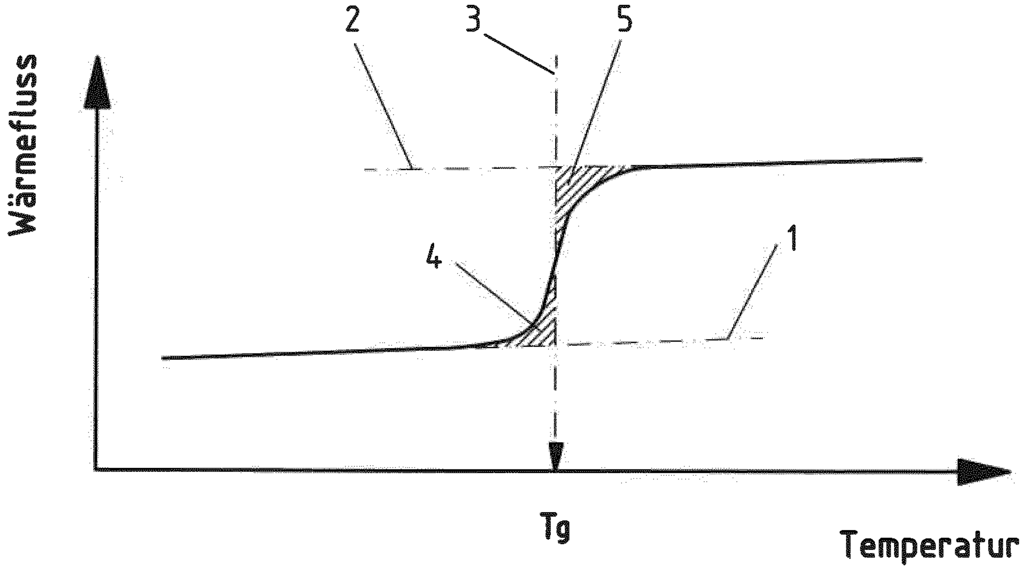


FIG.5

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- DE 102008047964 A1
- AU 758128 B2
- SG 160949 B
- EP 1028151 B1
- EP 620259 A1
- EP 721975 A
- DE 19519499 A1
- WO 9821287 A1
- US 4552604 A
- EP 2545132 A1
- EP 819746 A1
- EP 914027 A1
- WO 2013101693 A1
- WO 2015048012 A1
- WO 1999057216 A1
- WO 2012165259 A1
- US 20100137530 A1
- JP 2003336025 A
- US 6319603 B1
- JP 2008150406 A
- WO 2015082143 A1
- WO 9624620 A1
- WO 9844008 A1
- DE 19949352 A1
- US 5945491 A
- US 5854364 A
- US 5789487 A
- WO 9801478 A1
- WO 9931144 A1
- US 20140367670 A1
- US 5242715 A
- EP 393893 A1
- WO 2013156509 A2
- JP 2014062057 A
- JP 2012056915 A
- US 6908722 B1
- US 4231951 A
- US 4256828 A
- US 4058401 A
- US 4138255 A
- US 2010063221 A1
- US 3729313 A
- US 3741769 A
- US 4250053 A
- US 4394403 A
- EP 542716 B1
- EP 1743928 A1
- US 20070135552 A1
- WO 02026908 A1
- WO 0041978 A1
- EP 1832558 A1


### In der Beschreibung aufgeführte Nicht-Patentliteratur


- **E. M. PETRIE.** *Epoxy Adhesive Formulations,* 2006, 30ff
- **J. V. CRIVELLO.** *J. Polym. Sci. A Polym. Chem.,* 1999, vol. 37, 4241-54
- **U. W. GEDDE.** Polymer Physics. Kluwer, 1999, 70
- **T. FOX ; P. J. FLORY.** *J. Polym. Sei.,* 1954, vol. 14, 315-319
- Polymer Handbook. J. Wiley, 1999, vol. 1
- Houben-Weyl, Methoden der Organischen Chemie. vol. E 19a, 60-147
- *Macromolecules,* 2000, vol. 33, 243-245
- *J. Polym. Sci. A,* 1995, vol. 33, 505ff
- *J. Polym. Sci. B,* 2001, vol. 39, 2397ff
- *Macromolecules,* 1990, vol. 23, 431 ff
- *Macromolecules,* 1991, vol. 24, 2689
- *Macromol. Chem. Phys.,* 2001, vol. 202, 2554ff
- **C. DONKER.** *PSTC Annual Technical Seminar Proceedings,* Mai 2001, 149-164
- **VON A.G. ERLAT.** *47th Annual Technical Conference Proceedings-Society of Vacuum Coaters,* 2004, 654-659
- **VON M. E. GROSS et al.** *46th Annual Technical Conference Proceedings-Society of Vacuum Coaters,* 2003, 89-92